# EUROPÄISCHE PATENTSCHRIFT

(11) **EP 3 513 574 B1**
(45) Veröffentlichungstag und Bekanntmachung des Hinweises auf die Patenterteilung: **02.11.2022**
(21) Anmeldenummer: 17771716.2
(22) Anmeldetag: 13.09.2017
(51) Int. Cl.: H04R 17/00, H04R 3/00, H01L 41/04

(54) **VERFAHREN UND SCHALTUNG ZUM BETREIBEN EINES PIEZOELEKTRISCHEN MEMS-SCHALLWANDLERS SOWIE INTEGRIERTER SCHALTKREIS MIT EINER DERARTIGEN SCHALTUNG**
METHOD AND CIRCUIT FOR OPERATING A PIEZOELECTRIC MEMS SOUND TRANSDUCER AND INTEGRATED CIRCUITRY HAVING SUCH A CIRCUIT
PROCÉDÉ ET CIRCUIT DESTINÉS AU FONCTIONNEMENT D'UN TRANSDUCTEUR ACOUSTIQUE MEMS PIÉZOÉLECTRIQUE AINSI QUE CIRCUIT INTÉGRÉ POURVU D'UN TEL CIRCUIT

(30) Priorität: 14.09.2016 DE 102016117239
(43) Veröffentlichungstag der Anmeldung: 24.07.2019
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); HAENSLER, Markus, 8081 Heiligenkreuz am Waasen (AT)
(74) Vertreter: Canzler & Bergmeier Patentanwälte Partnerschaft mbB
(86) Internationale Anmeldenummer: PCT/EP2017/073050
(87) Internationale Veröffentlichungsnummer: WO 2018/050712

(56) Entgegenhaltungen:
- DE-A1-102005 014 929
- DE-T2- 69 432 643
- US-A- 4 947 074
- US-A1- 2010 271 147
- US-A1- 2013 320 954

## Beschreibung

Die vorliegende Erfindung betrifft ein Verfahren zum Betreiben eines als MEMS-Schallwandler ausgebildeten Piezo-Bauteils, bei dem in zumindest einem Energiespeicher eine elektrische Energie gespeichert wird. Der piezoelektrische MEMS-Schallwandler ist insbesondere ein im hörbaren Wellenlängenspektrum und/oder im Ultraschallbereich arbeitender MEMS-Lautsprecher. Der MEMS-Schallwandler kann somit insbesondere für Schall- und/oder Ultraschallanwendungen genutzt werden. Der MEMS-Schallwandler kann beispielsweise in der Medizintechnik Anwendung finden. Der MEMS-Schallwandler kann aber auch als Lautsprecher, insbesondere in Mobilgeräten, wie beispielsweise Kopfhörern, Mobiltelefonen oder Tablets, verwendet werden. Bei dem Verfahren wird mittels zumindest einer Umladeeinheit die elektrische Energie mittelbar zwischen dem Energiespeicher und dem als MEMS-Schallwandler ausgebildeten Piezo-Bauteil umgeladen. Des Weiteren betrifft die Erfindung eine Schaltung zum Betreiben des piezoelektrischen MEMS-Schallwandlers mit einem Energiespeicher, in dem elektrische Energie speicherbar ist. Die Energie wird mit zumindest einer Umladeeinheit zwischen dem Energiespeicher und dem piezoelektrischen MEMS-Schallwandler umgeladen. Ferner betrifft die Erfindung einen integrierten Schaltkreis mit einer derartigen Schaltung.

In der DE 10 2013 109 098 A1 ist ein Piezo-Treiber gezeigt, der konfiguriert ist, elektrische Ladung an ein Piezo-Bauteil zu liefern, und konfiguriert ist, elektrische Ladung von dem Piezo-Bauteil zu einem passiven Energiespeicherbauteil während verschiedener Betriebszustände des Piezo-Treibers zu übertragen. Der Piezo-Treiber enthält ferner einen Spannungswandler, der zur elektrischen Verbindung zwischen einem Piezo-Bauteil und dem ersten passiven Energiespeicherbauteil und einem zweiten passiven Energiespeicherbauteil konfiguriert ist. Der Spannungswandler ist konfiguriert, elektrische Ladung vom ersten passiven Energiespeicherbauteil sowie vom zweiten passiven Energiespeicherbauteil zum Piezo-Bauteil zu liefern, und umgekehrt. Nachteilig an diesem Piezo-Treiber ist, dass der Spannungswandler ineffektiv betrieben werden kann. Dies führt zu einer hohen Verlustleistung, die als Wärme von der Schaltung bzw. vom Piezo-Treiber abgeführt werden muss.

In der US 2010/0271147 A1 ist ein Verfahren zum Betreiben eines piezoelektrischen Schallwandlers offenbart, mit dem der Schallwandler effektiv betrieben werden kann, um eine Energieaufnahme zu reduzieren.

In der US 4,947,074 A ist eine Schaltung zum Aufladen eines Piezoelements in Bezug auf ein externes Signal offenbart.

In der US 2013/0320954 A1 ist ebenfalls ein Verfahren zum Betreiben eines piezoelektrischen Schallwandlers offenbart, bei dem Energie zurückgewonnen werden kann.

Aufgabe der Erfindung ist es somit, ein Verfahren sowie eine Schaltung zum Betreiben eines als piezoelektrischen MEMS-Schallwandler ausgebildeten Piezo-Bauteils zu schaffen, mit dem bzw. mit der der piezoelektrische MEMS-Schallwandler mit einer geringen Verlustleistung betrieben werden kann.

Die Aufgabe wird gelöst durch ein Verfahren sowie eine Schaltung zum Betreiben eines als piezoelektrischer MEMS-Schallwandler ausgebildeten Piezo-Bauteils gemäß den Merkmalen der unabhängigen Patentansprüche.

Vorgeschlagen wird ein Verfahren zum Betreiben eines Piezo-Bauteils, bei dem in zumindest einem Energiespeicher eine elektrische Energie gespeichert wird. Das Piezo-Bauteil ist, insbesondere in der gesamten nachfolgenden Beschreibung, als piezoelektrischer MEMS-Schallwandler ausgebildet. Ein derartiger MEMS-Schallwandler, umfasst vorzugsweise im Wesentlichen einen piezoelektrischen Aktor und eine vom Aktor auslenkbare Membran. Der MEMS-Schallwandler ist vorzugsweise ein im hörbaren Wellenlängenspektrum und/oder im Ultraschallbereich arbeitender MEMS-Lautsprecher. Der MEMS-Schallwandler findet vorzugsweise für Schall- und/oder Ultraschallanwendungen, wie beispielsweise in der Medizintechnik, Anwendung. Der MEMS-Schallwandler kann aber auch als MEMS-Lautsprecher verwendet werden Diese elektrische Energie wird zwischen dem Energiespeicher und dem als MEMS-Schallwandler ausgebildeten Piezo-Bauteils mittelbar über zumindest eine Umladeeinheit umgeladen.

Die zumindest eine Umladeeinheit und das als piezoelektrischer MEMS-Schallwandler ausgebildete Piezo-Bauteil sind zueinander in einer Parallelschaltung angeordnet. Dabei werden sie derart geschalten, dass zum Betreiben des als piezoelektrischer MEMS-Schallwandler ausgebildeten Piezo-Bauteils in einem ersten Schaltzustand zunächst die zumindest eine Umladeeinheit vom Energiespeicher geladen wird. Anschließend wird in einem zweiten Schaltzustand diese Umladeeinheit wieder entladen und das als piezoelektrischer MEMS-Schallwandler ausgebildete Piezo-Bauteil hierbei geladen.

Bei einer Aufladung des als piezoelektrischer MEMS-Schallwandler ausgebildeten Piezo-Bauteils mit elektrischer Energie lenkt es sich aus - es kommt zu einer Verformung des als piezoelektrischer MEMS-Schallwandler ausgebildeten Piezo-Bauteils. Mittels dieser Auslenkung bzw. Verformung können beispielsweise Schallwellen erzeugt werden. Das als piezoelektrischer MEMS-Schallwandler ausgebildete Piezo-Bauteil wird somit mittels des zweiten Schaltzustands ausgelenkt.

Zusätzlich wird zur Energierückgewinnung in einem dritten Schaltzustand das als piezoelektrischer MEMS-Schallwandler ausgebildete Piezo-Bauteil wieder entladen und die zumindest eine Umladeeinheit hierbei geladen. Anschließend wird in einem vierten Schaltzustand diese Umladeeinheit wieder entladen und der Energiespeicher hierbei geladen. Das als piezoelektrischer MEMS-Schallwandler ausgebildete Piezo-Bauteil kehrt bei der Entladung wieder in einen Ausgangszustand zurück. Durch die Energierückgewinnung kann das als piezoelektrischer MEMS-Schallwandler ausgebildete Piezo-Bauteil effektiver betrieben werden.

Vorteilhafterweise kann in der zumindest einen Umladeeinheit die elektrische Energie zumindest zeitweise gespeichert werden.

Bei der Erfindung wird die elektrische Energie schrittweise zwischen dem Energiespeicher und dem als piezoelektrischer MEMS-Schallwandler ausgebildeten Piezo-Bauteil umgeladen, so dass die elektrische Energie in Portionen umgeladen wird. Das als piezoelektrischer MEMS-Schallwandler ausgebildete Piezo-Bauteil kann eine Kapazität aufweisen, die durch das Verfahren bis zu einer gewissen Endspannung aufgeladen wird. Durch das schrittweise Aufladen des als piezoelektrischer MEMS-Schallwandler ausgebildeten Piezo-Bauteils mit einer elektrischen Energie wird auch die Spannung schrittweise bis zur Endspannung erhöht. Durch das schrittweise Aufladen wird die Verlustleistung während des Betriebs des als piezoelektrischer MEMS-Schallwandler ausgebildeten Piezo-Bauteils verringert. Selbiges gilt dabei für das Entladen bzw. bei der Energierückgewinnung des als piezoelektrischer MEMS-Schallwandler ausgebildeten Piezo-Bauteils.

Das schrittweise Aufladen erfolgt dabei derart, dass der erste Schaltzustand und der zweite Schaltzustand immer wieder wiederholt werden, so dass bei jedem Zyklus eine Energieportion auf das als piezoelektrischer MEMS-Schallwandler ausgebildete Piezo-Bauteil geladen wird.

Das Aufladen des als piezoelektrischer MEMS-Schallwandler ausgebildeten Piezo-Bauteils kann dabei derart durchgeführt werden, dass bei jedem Aufladeschritt die Spannung am als piezoelektrischer MEMS-Schallwandler ausgebildeten Piezo-Bauteil um einen konstanten Bruchteil der Endspannung erhöht wird. Zusätzlich oder alternativ kann die Spannung auch in unterschiedlichen Spannungen bis zur Endspannung erhöht werden. Beispielsweise kann die Spannung am als piezoelektrischer MEMS-Schallwandler ausgebildeten Piezo-Bauteil um 1/1000 der Endspannung erhöht werden, so dass 1000 Aufladeschritte durchgeführt werden, um die Endspannung am als piezoelektrischer MEMS-Schallwandler ausgebildeten Piezo-Bauteil zu erreichen. Mit der Endspannung ist daraufhin auch eine vorgesehene Auslenkung des als piezoelektrischer MEMS-Schallwandler ausgebildeten Piezo-Bauteils erreicht.

Mittels des schrittweisen Aufladens kann auch eine höhere Spannung erreicht werden, als beispielsweise am Energiespeicher bereitgestellt wird. Da die Spannung am als piezoelektrischer MEMS-Schallwandler ausgebildeten Piezo-Bauteil proportional zu einer elektrischen Ladung auf dem piezoelektrischen MEMS-Schallwandler ist und durch die Aufladeschritte Ladungen auf das als piezoelektrischer MEMS-Schallwandler ausgebildete Piezo-Bauteil geladen werden, kann die Spannung weiter erhöht werden. Dies kann beispielsweise auch durchgeführt werden, wenn die Spannung, die der Energiespeicher liefert, geringer ist als die momentane Spannung am als piezoelektrischer MEMS-Schallwandler ausgebildeten Piezo-Bauteil. Das Verfahren kann deshalb auch beispielsweise dazu angewandt werden, um aus einer geringeren Spannung, die beispielsweise der Energiespeicher bereitstellt, eine höhere Spannung am als piezoelektrischer MEMS-Schallwandler ausgebildeten Piezo-Bauteil zu erzeugen.

In einer vorteilhaften Weiterbildung der Erfindung wird zum Betreiben des als piezoelektrischer MEMS-Schallwandler ausgebildeten Piezo-Bauteils die elektrische Energie vom Energiespeicher im ersten Schaltzustand zuerst auf einem ersten Strompfad zumindest teilweise auf die erste Umladeeinheit übertragen. In einem anschließenden Schritt wird die elektrische Energie im zweiten Schaltzustand in einem ersten Stromkreis auf das als piezoelektrischer MEMS-Schallwandler ausgebildete Piezo-Bauteil zumindest teilweise umgeladen. Dadurch wird die Schaltung mit einem geringeren elektrischen Strom belastet, da lediglich der erste Strompfad oder der erste Stromkreis mit einem Strom belastet wird. Dabei wird, um beispielsweise in 1000 Aufladeschritten die Endspannung zu erreichen, dieser Vorgang entsprechend oft wiederholt. Dabei wird, um 1000 Aufladeschritte durchzuführen, der Zyklus des Aufladens der zumindest einen Umladeeinheit und das anschließende Umladen auf das als piezoelektrischer MEMS-Schallwandler ausgebildete Piezo-Bauteil 1000 mal durchgeführt. Dabei wird beispielsweise bei jedem Aufladeschritt die Spannung des als piezoelektrischer MEMS-Schallwandler ausgebildeten Piezo-Bauteils um 1/1000 der Endspannung erhöht. Außerdem wird dadurch bei jedem Aufladeschritt eine entsprechend geringe elektrische Energie vom Energiespeicher über die erste Umladeeinheit auf das als piezoelektrischer MEMS-Schallwandler ausgebildeten Piezo-Bauteil umgeladen, so dass die daran beteiligten elektrischen Bauteile, wie beispielsweise Leiterbahnen, klein gehalten werden können, da entsprechend geringere Energien umgeladen werden. Außerdem weist ein derartiges Aufladen eine hohe Effektivität auf, so dass nur wenig Energie während des kompletten Ladevorgangs verloren geht bzw. in Wärme umgesetzt wird.

Zusätzlich wird zur Energierückgewinnung die elektrische Energie des als piezoelektrischer MEMS-Schallwandler ausgebildeten Piezo-Bauteils im dritten Schaltzustand zuerst in dem ersten Stromkreis von dem als piezoelektrischer MEMS-Schallwandler ausgebildeten Piezo-Bauteil auf die erste Umladeeinheit umgeladen und anschließend im vierten Schaltzustand auf dem ersten Strompfad auf den Energiespeicher übertragen. Die Energierückgewinnung erfolgt ebenfalls schrittweise, so dass bei dem Entladen des als piezoelektrischer MEMS-Schallwandler ausgebildeten Piezo-Bauteils die Verlustleistung ebenfalls verringert ist, da bei jedem Entladeschritt nur eine geringe Menge elektrischer Energie in den Energiespeicher zurückgespeichert wird. Dies kann beispielsweise ebenfalls in 1000 Schritten durchgeführt werden.

In einer zusätzlichen Weiterbildung der Erfindung ist es von Vorteil, wenn mittels einer zweiten Umladeeinheit die elektrische Energie zwischen dem Energiespeicher und dem als piezoelektrischer MEMS-Schallwandler ausgebildeten Piezo-Bauteil umgeladen wird, so dass das als piezoelektrischer MEMS-Schallwandler ausgebildete Piezo-Bauteil zum Betreiben geladen und/oder zur Energierückgewinnung entladen wird.

Dabei wird zum Betreiben des als piezoelektrischer MEMS-Schallwandler ausgebildeten Piezo-Bauteils die elektrische Energie vom Energiespeicher in einem fünften Schaltzustand zuerst auf einem zweiten Strompfad durch die zumindest eine zweite Umladeeinheit auf diese übertragen. Anschließend wird in einem sechsten Schaltzustand die elektrische Energie in zumindest einem zweiten Stromkreis von der zweiten Umladeeinheit auf das als piezoelektrischer MEMS-Schallwandler ausgebildeten Piezo-Bauteil zumindest teilweise umgeladen.

Zusätzlich wird zur Energierückgewinnung die elektrische Energie des als piezoelektrischer MEMS-Schallwandler ausgebildeten Piezo-Bauteils in einem siebten Schaltzustand zuerst in dem zweiten Stromkreis von dem als piezoelektrischer MEMS-Schallwandler ausgebildeten Piezo-Bauteil auf die zweite Umladeeinheit umgeladen. In einem achten Schaltzustand wird anschließend die elektrische Energie auf dem zweiten Strompfad in dem Energiespeicher gespeichert.

Dabei kann der fünfte bis achte Schaltzustand der zweiten Umladeeinheit den gleichen oder ähnlichen Schaltzustand wie der erste bis vierte Schaltzustand beschreiben. Das Weiterzählen der Schaltzustände wurde lediglich zur Unterscheidung eines möglichen anderen Schaltzustandes gewählt. Im Wesentlichen führen der erste und der fünfte Schaltzustand zu einem Laden der jeweiligen Umladeeinheiten. Der zweite und der sechste Schaltzustand führen zu einem Umladen der Energie von der jeweiligen Umladeeinheit auf das als piezoelektrischer MEMS-Schallwandler ausgebildete Piezo-Bauteil. Der dritte und der siebte Schaltzustand führen zu einem zurückladen der Energie vom als piezoelektrischer MEMS-Schallwandler ausgebildeten Piezo-Bauteil auf die jeweilige Umladeeinheit, um Energie zurückzugewinnen. Der vierte und der achte Schaltzustand führen zu einem Umladen der Energie von der jeweiligen Umladeeinheit zurück in den Energiespeicher. Dabei können die zusammengehörenden Schaltzustände, beispielsweise der erste und der fünfte, der gleiche Schaltzustand sein.

Mittels der zweiten Umladeeinheit kann das Verfahren flexibler durchgeführt werden.

Ebenfalls ist es von Vorteil, wenn während des Umladens der elektrischen Energie in dem ersten Stromkreis von der ersten Umladeeinheit auf das als piezoelektrischer MEMS-Schallwandler ausgebildete Piezo-Bauteil elektrische Energie auf dem zweiten Strompfad von dem Energiespeicher auf die zweite Umladeeinheit übertragen wird.

Zusätzlich ist es von Vorteil, wenn während des Umladens der elektrischen Energie in dem zweiten Stromkreis von der zweiten Umladeeinheit auf das als piezoelektrischer MEMS-Schallwandler ausgebildete Piezo-Bauteil elektrische Energie auf dem ersten Strompfad von dem Energiespeicher auf die erste Umladeeinheit übertragen und/oder gespeichert wird.

Dadurch kann das Ladeverfahren des als piezoelektrischer MEMS-Schallwandler ausgebildeten Piezo-Bauteils verkürzt werden, da gleichzeitig von einer Umladeeinheit die Energie auf das als piezoelektrischer MEMS-Schallwandler ausgebildete Piezo-Bauteil übertragen und zeitgleich die jeweilig andere Umladeeinheit von dem Energiespeicher aufgeladen wird.

Die Energierückgewinnung kann daraufhin ebenfalls parallel ablaufen. Beispielsweise wenn die Energie von dem als piezoelektrischer MEMS-Schallwandler ausgebildeten Piezo-Bauteil auf die erste Umladeeinheit übertragen wird, kann eine vorher von dem Piezo-Bauteil in der zweiten Umladeeinheit gespeicherte Energie auf den Energiespeicher übertragen werden. Dadurch kann ebenfalls die Energierückgewinnung beschleunigt werden.

Zusätzlich kann auch die Energie von dem als piezoelektrischer MEMS-Schallwandler ausgebildeten Piezo-Bauteil auf die zweite Umladeeinheit übertragen werden und eine vorher von dem Piezo-Bauteil in der erste Umladeeinheit gespeicherte Energie auf den Energiespeicher übertragen werden.

Vorteilhaft ist es des Weiteren, wenn zum Ausgleichen von Energieverlusten die elektrische Energie in dem Energiespeicher, der zumindest einen ersten Umladeeinheit und/oder zumindest einen zweiten Umladeeinheit erhöht wird. Die Energieverluste können dabei mittels einer Energieversorgung ausgeglichen werden. Die Energie kann dabei beispielsweise in einem entsprechenden Bauteil erhöht werden, dessen Energie gerade nicht umgeladen wird.

Des Weiteren ist es von Vorteil, wenn die Schaltung eine Vielzahl an Schalteinheiten und/oder Schalter umfasst, die geöffnet und/oder geschlossen werden um die verschiedenen Schaltzustände auszubilden, wobei der erste Strompfad, der zweite Strompfad, der erste Stromkreis und/oder der zweite Stromkreis unterbrochen und/oder durchleitend wird. Dadurch wird die elektrische Energie auf ein entsprechendes Bauteil umgeladen und ein Umladen von Energie auf die jeweilig anderen Bauteile verhindert. Zusätzlich oder alternativ kann die Schaltung auch Dioden umfassen, die derart angeordnet sind, dass der Strom in einer Richtung blockiert ist. Beispielsweise weist der erste Strompfad eine Schalteinheit auf, der zu Beginn den Strom nicht leitet, so dass der erste Strompfad unterbrochen ist. Wird diese Schalteinheit leitend, kann die elektrische Energie auf dem ersten Strompfad umgeladen werden. Die Energie wird dadurch zwischen dem Energiespeicher und der ersten Umladeeinheit umgeladen. Die jeweilig anderen Schalteinheiten, Schalter und/oder Dioden sind dabei derart geschaltet und/oder angeordnet, dass die Energie auf ein anderes Bauteil verhindert wird. Beispielsweise weist der erste Stromkreis eine Diode auf, die derart angeordnet ist, dass während die Energie auf dem ersten Strompfad auf die erste Umladeeinheit umgeladen wird, ein Strom in dem ersten Stromkreis verhindert ist.

Die Schalteinheit kann ferner selbst beispielsweise eine Diode und/oder einen Schalter umfassen. Mittels der Diode kann ein Strom in einer Richtung blockiert werden, so dass beispielsweise zwar ein Strom von einer Umladeeinheit in das als piezoelektrischer MEMS-Schallwandler ausgebildete Piezo-Bauteil möglich ist, jedoch der Strom aus dem Piezo-Bauteil in die Umladeeinheit zurück blockiert ist. Beispielsweise kann mittels eines Schalters die Diode zumindest zeitweise überbrückt werden, um zumindest zeitweise den Strom auch entgegen der Diode (durch das Überbrücken der Diode) zu leiten. Dies kann beispielsweise dann durchgeführt werden, um im eben genannten Beispiel die Energie des Piezo-Bauteils auf die Umladeeinheit zu laden.

Die Schalteinheiten und/oder die Schalter werden dabei von einer Steuerung geschalten.

Ferner ist es von Vorteil, wenn der Energiespeicher und zumindest eine erste und/oder zumindest eine zweite Umladeeinheit. Zusätzlich oder alternativ können auch zumindest eine erste und/oder zweite Umladeeinheit und das als piezoelektrischer MEMS-Schallwandler ausgebildete Piezo-Bauteil einen elektrischen, insbesondere resonanten, Schwingkreis ausbilden. Dabei werden die Schalter und/oder die Schalteinheiten vorzugsweise derart geschalten, dass in einem Stromnulldurchgang des jeweiligen Schwingkreises geschalten wird. Dadurch werden die Schalter geschalten, wenn die vollständige elektrische Energie umgeladen ist.

Des Weiteren wird eine Schaltung zum Betreiben eines als piezoelektrischer MEMS-Schallwandler ausgebildeten Piezo-Bauteils vorgeschlagen, die zumindest einen Energiespeicher, in dem elektrische Energie speicherbar ist, umfasst. Des Weiteren umfasst die Schaltung ein Piezo-Bauteil. Das Piezo-Bauteil ist, insbesondere in der gesamten nachfolgenden Beschreiung, als piezoelektrischer MEMS-Schallwandler ausgebildet. Ein derartiger MEMS-Schallwandler, umfasst vorzugsweise im Wesentlichen einen piezoelektrischen Aktor und eine vom Aktor auslenkbare Membran. Der MEMS-Schallwandler ist vorzugsweise ein im hörbaren Wellenlängenspektrum und/oder im Ultraschallbereich arbeitender MEMS-Lautsprecher. Der MEMS-Schallwandler findet vorzugsweise für Schall- und/oder Ultraschallanwendungen, wie beispielsweise in der Medizintechnik, Anwendung. Der MEMS-Schallwandler kann aber auch als MEMS-Lautsprecher verwendet werden.

Außerdem umfasst die Schaltung zumindest eine Umladeeinheit, mittels der die elektrische Energie zwischen dem Energiespeicher und dem als piezoelektrischer MEMS-Schallwandler ausgebildeten Piezo-Bauteil umladbar ist.

Erfindungsgemäß sind die zumindest eine Umladeeinheit und das als piezoelektrischer MEMS-Schallwandler ausgebildete Piezo-Bauteil in einer Parallelschaltung zueinander angeordnet. Des Weiteren wird die Schaltung gemäß zumindest einem Merkmal der vorangegangenen und/oder nachfolgenden Beschreibung betrieben. Durch die Parallelschaltung kann die Umladeeinheit unabhängig von dem als piezoelektrischer MEMS-Schallwandler ausgebildeten Piezo-Bauteil mit elektrischer Energie aufgeladen werden.

Beispielsweise kann mittels der Parallelschaltung zum Betrieb des als piezoelektrischer MEMS-Schallwandler ausgebildeten Piezo-Bauteils in dem ersten Schaltzustand die Umladeeinheit aufgeladen werden. In diesem ersten Schaltzustand wird das als piezoelektrischer MEMS-Schallwandler ausgebildete Piezo-Bauteil nicht von dieser Umladeeinheit und vom Energiespeicher aufgeladen. Erst in einem anschließenden Schritt, in dem zweiten Schaltzustand, wird die elektrische Energie von der Umladeeinheit auf das als piezoelektrischer MEMS-Schallwandler ausgebildete Piezo-Bauteil umgeladen. Dadurch kann das Aufladen des als piezoelektrischer MEMS-Schallwandler ausgebildeten Piezo-Bauteils effektiver durchgeführt werden.

Dabei kann der Zyklus, bei dem die Umladeeinheit vom Energiespeicher aufgeladen wird und die Umladeeinheit daraufhin die Energie an das Piezo-Bauteil abgibt, mehrfach wiederholt werden. Dabei sieht der Zyklus der Schaltzustände wie folgt aus. Zuerst erfolgt der erste Schaltzustand, in dem die Umladeeinheit von dem Energiespeicher geladen wird. Daraufhin folgt der zweite Schaltzustand, so dass die Energie von der Umladeeinheit auf das als piezoelektrischer MEMS-Schallwandler ausgebildete Piezo-Bauteil geladen wird. Anschließend beginnt der Zyklus wieder bei dem ersten Schaltzustand und zwar solange, bis eine Gesamtenergie auf das als piezoelektrischer MEMS-Schallwandler ausgebildete Piezo-Bauteil geladen ist. Dadurch kann die Effektivität der Schaltung erhöht werden. Insbesondere sinken dadurch Energieverluste der Schaltung.

Dadurch kann auch am als piezoelektrischer MEMS-Schallwandler ausgebildeten Piezo-Bauteil eine höhere Spannung erreicht werden als beispielsweise von dem Energiespeicher bereitgestellt wird. Durch das schrittweise Aufladen kann eine Ladung des als piezoelektrischer MEMS-Schallwandler ausgebildeten Piezo-Bauteils erhöht werden. Die Ladung auf dem Piezo-Bauteil ist dabei proportional zur gegenwärtigen Spannung des Piezo-Bauteils.

Zusätzlich kann die Energierückgewinnung auch mit einem Entladezyklus durchgeführt werden. Zur Energierückgewinnung über die Umladeeinheit weist die Schaltung einen dritten Schaltzustand auf, bei dem die elektrische Energie von dem als piezoelektrischer MEMS-Schallwandler ausgebildeten Piezo-Bauteil auf die Umladeeinheit geladen wird. Anschließend wird die elektrische Energie in einem vierten Schaltzustand von der Umladeeinheit auf den Energiespeicher geladen.

Die Schaltung weist ferner vorteilhafterweise einen ersten Strompfad, der durch eine erste Umladeeinheit führt, und einen dritten Strompfad, der durch das Piezo-Bauteil führt, auf. Der erste Strompfad und der dritte Strompfad können dabei unabhängig voneinander mit einem elektrischen Strom beaufschlagt werden. Dadurch kann die elektrische Energie auf dem ersten Strompfad von dem Energiespeicher auf die erste Umladeeinheit übertragen werden. Durch die Parallelschaltung kann ein Umladen von Energie in diesem Schritt auf das als piezoelektrischer MEMS-Schallwandler ausgebildete Piezo-Bauteil verhindert werden. Erst anschließend kann dann die Energie von der ersten Umladeeinheit auf das Piezo-Bauteil übertragen werden. Dadurch kann die elektrische Energie in einem ersten Schritt im ersten Schaltzustand von dem Energiespeicher zuerst auf die erste Umladeeinheit umgeladen werden. Erst in einem nachfolgenden Schritt im zweiten Schaltzustand kann die auf die ersten Umladeeinheit umgeladene Energie innerhalb der Parallelschaltung bzw. über den ersten Stromkreis auf das Piezo-Bauteil umgeladen werden. Dieses Umladen der Energie zuerst auf die erste Umladeeinheit und anschließend auf das Piezo-Bauteil kann in einer Vielzahl an Schritten durchgeführt werden, so dass jeweils nur eine kleine Menge Energie umgeladen wird. Dadurch kann eine Effektivität der Schaltung erhöht werden. Dabei werden insbesondere Verlustleistungen, die in Wärme umgewandelt werden und die abgeführt werden müssen, verringert. Die Schaltung kann dadurch kostengünstiger betrieben werden. Durch die schrittweise Umladung der Energie kann die Schaltung auch kleiner bzw. kompakter ausgebildet werden, da bei jedem Schritt dementsprechend weniger Energie umgeladen wird, so dass die Bauteile einer geringeren Belastung ausgesetzt sind. Beispielsweise fließen geringe elektrische Ströme, so dass beispielsweise Leiterbahnen kleiner ausgebildet werden können.

Beispielsweise kann in dem ersten Schaltzustand die Umladeeinheit vom Energiespeicher geladen werden, wobei in dem ersten Schaltzustand der erste Strompfad leitend geschaltet wird.

Beispielsweise kann in dem zweiten Schaltzustand die Energie auf dem ersten Stromkreis von der Umladeeinheit auf das als piezoelektrischer MEMS-Schallwandler ausgebildete Piezo-Bauteil geladen werden. Dazu wird der erste Stromkreis leitend geschaltet. Zusätzlich kann der erste Strompfad unterbrochen werden.

Beispielsweise kann in dem dritten Schaltzustand die Energie zur Energierückgewinnung vom als piezoelektrischer MEMS-Schallwandler ausgebildeten Piezo-Bauteil in dem ersten Stromkreis auf die erste Umladeeinheit geladen werden. Dazu wird der erste Stromkreis leitend geschaltet. Zusätzlich kann der erste Strompfad unterbrochen werden, so dass ein Strom in den Energiespeicher blockiert ist.

Beispielsweise kann in dem vierten Schaltzustand die Energie zur Energierückgewinnung von der ersten Umladeeinheit auf dem ersten Strompfad auf den Energiespeicher geladen werden. Dabei wird der erste Strompfad leitend geschaltet. Zusätzlich kann der erste Stromkreis unterbrochen werden, so dass ein Strom in das als piezoelektrischer MEMS-Schallwandler ausgebildete Piezo-Bauteil blockiert ist.

In einer vorteilhaften Weiterbildung der Erfindung umfasst die Schaltung eine zweite Umladeeinheit, mittels der die elektrische Energie zwischen dem Energiespeicher und dem als piezoelektrischer MEMS-Schallwandler ausgebildeten Piezo-Bauteil umladbar ist. Das Umladen der Energie kann auch hier in beide Richtungen erfolgen. Zum Betreiben kann das Piezo-Bauteil geladen werden. Die Energie wird vom Energiespeicher auf die zweite Umladeeinheit geladen und von dort auf das Piezo-Bauteil übertragen. Zur Energierückgewinnung kann das Piezo-Bauteil entladen werden. Die Energie kann dazu von dem Piezo-Bauteil auf die zweite Umladeeinheit übertragen und von dort in den Energiespeicher zurückübertragen werden.

Dabei sind die zweite Umladeeinheit und das als piezoelektrischer MEMS-Schallwandler ausgebildete Piezo-Bauteil in einer Parallelschaltung angeordnet, so dass ein zweiter Strompfad durch die zweite Umladeeinheit und der dritte Strompfad durch das Piezo-Bauteil unabhängig voneinander mit einem elektrischen Strom beaufschlagbar sind. Dadurch kann in einem ersten Schritt zuerst die Energie auf die zweite Umladeeinheit übertragen werden und anschließend auf das Piezo-Bauteil. Dadurch kann das als piezoelektrischer MEMS-Schallwandler ausgebildete Piezo-Bauteil schrittweise, beispielsweise in 1000 Schritten, aufgeladen werden, so dass die Effektivität des Betriebs des Piezo-Bauteils erhöht ist.

Dabei kann beispielsweise in einem fünften Schaltzustand die Energie vom Energiespeicher auf die zweite Umladeeinheit geladen werden. Dabei ist der zweite Strompfad leitend. Außerdem wird ein Strom in dem zweiten Stromkreis blockiert, so dass ein Strom zum als piezoelektrischer MEMS-Schallwandler ausgebildeten Piezo-Bauteil verhindert ist.

Beispielsweise kann in einem sechsten Schaltzustand die Energie von der zweiten Umladeeinheit auf das als piezoelektrischer MEMS-Schallwandler ausgebildete Piezo-Bauteil geladen werden. Dabei ist der zweite Strompfad unterbrochen, wohingegen der zweite Stromkreis leitend ist.

Beispielsweise kann auch hier die Energierückgewinnung durchgeführt werden. Beispielsweise kann in einem siebten Schaltzustand die Energie vom als piezoelektrischer MEMS-Schallwandler ausgebildeten Piezo-Bauteil auf die zweite Umladeeinheit geladen werden. Hier ist der zweite Stromkreis leitend, wohingegen der zweite Strompfad blockiert ist, so dass ein Strom zum Energiespeicher verhindert ist.

Beispielsweise kann in einem achten Schaltzustand die Energie dann von der zweiten Umladeeinheit auf den Energiespeicher geladen werden. Dabei ist der zweite Strompfad leitend. Der zweite Stromkreis ist blockiert, so dass ein Strom in das als piezoelektrischer MEMS-Schallwandler ausgebildete Piezo-Bauteil verhindert ist.

Ebenfalls ist es von Vorteil, wenn die erste Umladeeinheit und die zweite Umladeeinheit in einer Parallelschaltung angeordnet sind, so dass der erste Strompfad und der zweite Strompfad unabhängig voneinander mit Strom beaufschlagbar sind. Dadurch kann die erste Umladeeinheit gesondert von der zweiten Umladeeinheit zur Umladung von Energie benutzt werden.

Von Vorteil ist es außerdem, wenn die zumindest eine erste Umladeeinheit und das als piezoelektrischer MEMS-Schallwandler ausgebildete Piezo-Bauteil derart zueinander angeordnet sind, dass ein erster Stromkreis ausgebildet ist. Der erste Stromkreis führt somit durch die erste Umladeeinheit und durch das Piezo-Bauteil.

Zusätzlich können die zweite Umladeeinheit und das als piezoelektrischer MEMS-Schallwandler ausgebildete Piezo-Bauteil derart zueinander angeordnet sein, das ein zweiter Stromkreis ausgebildet ist. Der zweite Stromkreis führt somit durch die zweite Umladeeinheit und durch das Piezo-Bauteil.

Durch den ersten und/oder zweiten Stromkreis kann bei dem Umladen der Energie von der ersten bzw. zweiten Umladeeinheit auf das als piezoelektrischer MEMS-Schallwandler ausgebildete Piezo-Bauteil ein Strom auf den jeweiligen Stromkreis begrenzt (d.h. der Strom ist nur in dem jeweiligen Stromkreis ausgebildet) werden. Dadurch werden beispielsweise Bauteile außerhalb des ersten bzw. zweiten Stromkreises nicht belastet.

Vorteilhaft ist es des Weiteren, wenn die erste Umladeeinheit und/oder die zweite Umladeeinheit eine Energiespeichereinheit umfasst, so dass in den Umladeeinheiten die elektrische Energie speicherbar ist. Die Energiespeichereinheit kann beispielsweise eine Spule umfassen, die eine Induktivität aufweist. Die Energie kann dabei in der Spule in einem magnetischen Feld gespeichert werden. Die Spule erzeugt dabei das magnetische Feld, wenn durch die Spule und somit auf dem ersten bzw. zweiten Strompfad ein elektrischer Strom fließt. Die Spule kann die Energie wieder abgeben, so dass sie einen Strom erzeugt.

Ferner ist es von Vorteil, wenn der Energiespeicher einen Kondensator mit einer Kapazität umfasst, so dass darin die elektrische Energie speicherbar ist. Der Kondensator kann dabei die Energie in einem elektrischen Feld speichern und wieder abgeben.

Von Vorteil ist es des Weiteren, wenn der Energiespeicher und die erste und/oder die zweite Umladeeinheit einen elektrischen Schwingkreis ausbilden. Zusätzlich oder alternativ können auch die erste und/oder die zweite Umladeeinheit und das als piezoelektrischer MEMS-Schallwandler ausgebildete Piezo-Bauteil einen elektrischen Schwingkreis ausbilden. Dadurch kann die in dem elektrischen Schwingkreis gespeicherte elektrische Energie zwischen den jeweiligen Bauteilen schwingen. Dabei kann der Schwingkreis ein resonanter Schweinkreis sein, so dass die Energie ohne einen Erreger schwingen kann.

Von Vorteil ist es auch, wenn die Schaltung eine Energieversorgung aufweist, mittels der ein Energieverlust ausgleichbar ist. Außerdem ist die Energieversorgung mit dem Energiespeicher, mit der ersten Umladeeinheit und/oder mit der zweiten Umladeeinheit verbunden, so dass der Energieverlust mittels Erhöhung der elektrischen Energie in dem Energiespeicher, in der ersten Umladeeinheit und/oder in der zweiten Umladeeinheit ausgleichbar ist. Die Energieversorgung kann beispielsweise mit dem Energiespeicher elektrisch verbunden sein, so dass die Energie in dem Energiespeicher mittels eines elektrischen Stroms ausgleichbar ist. Zusätzlich oder alternativ kann die Energieversorgung beispielsweise auch mit einer Umladeeinheit magnetisch verbunden sein. Wenn eine Umladeeinheit beispielsweise eine Spule umfasst, kann eine Energie nach einem Transformatorprinzip mittels eines magnetischen Wechselfeldes in die Spule eingespeist werden.

Eine vorteilhafte Weiterbildung der Erfindung ist es, wenn die Schaltung eine Steuerung und eine Vielzahl an Schalteinheiten und/oder Schalter und/oder Dioden aufweist, so dass die jeweiligen Schaltzustände ausbildbar sind, wobei die Schalteinheiten und/oder Schalter derart mittels der Steuerung angesteuert werden können, dass der erste, der zweite, der dritte Strompfad, der erste Stromkreis und/oder der zweite Stromkreis unterbrechbar und/oder leitbar ist. Dadurch kann ein elektrischer Strom in den jeweiligen Strompfaden und/oder Stromkreisen unterbrochen werden. Zusätzlich oder alternativ kann der jeweilige Strompfad und/oder Stromkreis auch wieder leitend geschalten werden. Die Schalter und/oder Schalteinheiten können dabei beispielsweise Transistoren, wie beispielsweise Bipolartransistoren und/oder Feldeffekttransistoren, umfassen. Mittels der Steuerung werden die Transistoren geschalten, so dass beispielsweise ein Ton mit einer Frequenz von 1000 Hz erzeugt werden kann. Die Steuerung schaltet dabei die Schalter derart, dass das als piezoelektrischer MEMS-Schallwandler ausgebildete Piezo-Bauteil in 1 ms (1/1000 Hz) eine Periode des Tons ausführt. Dabei wird das Piezo-Bauteil in dieser 1 ms einmal vollständig aufgeladen und anschließend wieder entladen. Das Aufladen kann beispiels-weise in einer halben Periode, also in 0,5 ms, durchgeführt. Wenn das Aufladen dabei in 1000 Schritten durchgeführt wird, schaltet die Steuerung die Schalter mit einer Frequenz von 2 MHz. Dabei kann die Steuerung die Schalter auch mit einer höheren Frequenz ansteuern. Beispielsweise kann die Steuerung die Schalter auch mit 500 MHz ansteuern, wenn eine höhere Tonfrequenz erzeugt und/oder mehr Aufladeschritte durchgeführt werden sollen.

Zusätzlich oder alternativ kann das Aufladen auch länger dauern als das Entladen des als piezoelektrischer MEMS-Schallwandler ausgebildeten Piezo-Bauteils. Beispielsweise kann das Aufladen 75% und das Entladen 25% eines Zyklus Aufladen-Entladen betragen.

Ebenso ist es vorteilhaft, wenn die Schalteinheiten zumindest einen Schalter und/oder Dioden umfassen, die den elektrischen Strom wahlweise in beide und/oder einer Richtung unterbrechen kann und/oder in beide Richtungen durchlassen kann, so dass ein Fluss der elektrischen Energie in das und/oder aus dem als piezoelektrischer MEMS-Schallwandler ausgebildeten Piezo-Bauteil steuerbar ist. Ist die Schalteinheit beispielsweise in einem Schwingkreis angeordnet und sperrt den Strom in eine Richtung, kann der Strom nur in eine Richtung schwingen. Die elektrische Energie, die in dem Schwingkreis beispielsweise zwischen der Umladeeinheit und dem Piezo-Bauteil schwingt, kann dann lediglich von der Umladeeinheit auf das Piezo-Bauteil schwingen. Beispielsweise verhindert die Diode in der Schalteinheit, dass die Energie wieder zurück schwingt. Um die Energie wieder von dem Piezo-Bauteil auf diese Umladeeinheit zurück-zuladen, kann die Schalteinheit beispielsweise mittels der Steuerung angesteuert werden, um beispielsweise von dem Zustand, in der die Schalteinheit, beispielsweise mit einer Diode, in einer Richtung sperrt, in einen Zustand zu schalten, in der die Schalteinheit in beide Richtungen den Strom leitet. Die Diode in der Schalteinheit kann beispielsweise kurzzeitig überbrückt werden. Die Schalteinheit kann dabei beispielsweise in dem ersten, in dem zweiten, in dem dritten, in dem ersten und/oder in dem zweiten Stromkreis angeordnet sein.

Ferner wird ein integrierter Schaltkreis vorgeschlagen, der eine Schaltung umfasst, die gemäß zumindest einem der Merkmale der vorangegangenen und/oder nachfolgenden Beschreibung ausgebildet ist. Der integrierte Schaltkreis kann beispielsweise ein ASIC sein.

Weitere Vorteile der Erfindung sind in den nachfolgenden Ausführungsbeispielen beschrieben. Es zeigen:
- **Figur 1**: ein Blockschaltbild einer Schaltung zum Betreiben eines als piezoelektrischer MEMS-Schallwandler ausgebildeten Piezo-Bauteils mit einem Energiespeicher, einer Umladeeinheit und einem als piezoelektrischer MEMS-Schallwandler ausgebildeten Piezo-Bauteil,
- **Figur 2**: ein Blockschaltbild einer Schaltung zum Betreiben eines als piezoelektrischer MEMS-Schallwandler ausgebildeten Piezo-Bauteils mit einem Energiespeicher und zwei Umladeeinheiten und
- **Figur 3**: ein Blockschaltbild einer alternativen Schaltung zum Betreiben eines als piezoelektrischer MEMS-Schallwandler ausgebildeten Piezo-Bauteils mit einem Energiespeicher und zwei Umladeeinheiten.

In den nachfolgenden Figuren ist ein Piezo-Bauteil gezeigt, das als piezoelektrischer MEMS-Schallwandler 4 ausgebildet ist. Ein derartiger MEMS-Schallwandler 4, umfasst vorzugsweise im Wesentlichen einen piezoelektrischen Aktor und eine vom Aktor auslenkbare Membran. Der MEMS-Schallwandler 4 ist vorzugsweise ein im hörbaren Wellenlängenspektrum und/oder im Ultraschallbereich arbeitender MEMS-Lautsprecher. Der MEMS-Schallwandler findet vorzugsweise für Schall- und/oder Ultraschallanwendungen, wie beispielsweise in der Medizintechnik, Anwendung. Der MEMS-Schallwandler kann aber auch als MEMS-Lautsprecher, wie z.B. Mobiltelefonen oder Tablets; verwendet werden.

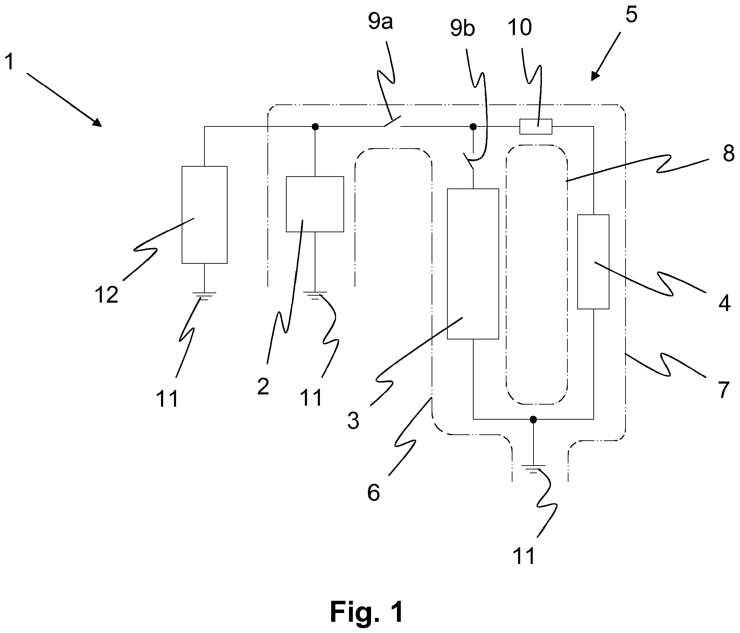

Figur 1 zeigt ein Blockschaltbild einer Schaltung 1 zum Betreiben eines piezoelektrischen MEMS-Schallwandlers 4 mit einem Energiespeicher 2, einer Umladeeinheit 3 und einem piezoelektrischen MEMS-Schallwandler 4. Das piezoelektrischer MEMS-Schallwandler 4 kann vorzugsweise für Schall- und/oder Ultraschallanwendungen, beispielsweise in der Medizintechnik, genutzt werden. Der piezoelektrische MEMS-Schallwandler 4 kann aber auch für Soundsysteme, beispielsweise Kopfhörer, als Lautsprecher verwendet werden.

Der piezoelektrischer MEMS-Schallwandler 4 weist die Eigenschaft auf, dass er sich beim Aufladen mit elektrischer Energie verformt - es kommt zu einer Auslenkung des piezoelektrischen MEMS-Schallwandlers 4, insbesondere eines Aktors, der mit einer Membran gekoppelt ist, die somit in Schwingung versetzt werden kann. Insbesondere lenkt sich der piezoelektrische MEMS-Schallwandler 4, bzw. insbesondere dessen piezoelektrischer Aktor, beim Aufladen mit elektrischen Ladungen aus. Abhängig von einer Amplitude und/oder einer Frequenz der Auslenkung können daraufhin Schallwellen mit einer Schallamplitude und/oder Schallfrequenz erzeugt werden.

Der piezoelektrische MEMS-Schallwandler 4 kann auch eine Kapazität aufweisen. Der piezoelektrische MEMS-Schallwandler 4 wird dabei mit elektrischen Ladungen aufgeladen, so dass die elektrische Energie in einem elektrischen Feld gespeichert wird. Der piezoelektrische MEMS-Schallwandler 4 weist somit ähnliche Eigenschaften wie ein Kondensator auf.

Um die elektrische Energie für den piezoelektrischen MEMS-Schallwandler 4 bereitzustellen, weist die Schaltung 1 den Energiespeicher 2 auf, in dem die elektrische Energie gespeichert werden kann.

Die Schaltung 1 umfasst des Weiteren eine Umladeeinheit 3, mittels der die elektrische Energie zwischen dem Energiespeicher 2 und dem piezoelektrischen MEMS-Schallwandler 4 umgeladen werden kann. Das Umladen der elektrischen Energie kann dabei in beide Richtungen erfolgen. Um den piezoelektrischen MEMS-Schallwandler 4 zu betreiben, kann die Umladeeinheit 3 die elektrische Energie vom Energiespeicher 2 auf den piezoelektrischen MEMS-Schallwandler 4 umladen, so dass der piezoelektrische MEMS-Schallwandler 4 geladen wird. Durch das Aufladen des piezoelektrischen MEMS-Schallwandlers 4 wird dieser - bzw. dessen piezoelektrischer Aktor und/oder Aktuatorstruktur - ausgelenkt, so dass Schallwellen erzeugt werden können.

Für eine Energierückgewinnung, kann die Umladeeinheit 3 die elektrische Energie vom piezoelektrischen MEMS-Schallwandler 4 wieder zurück auf den Energiespeicher 2 umladen, so dass sie dort wieder gespeichert wird. Mittels der Energierückgewinnung kann die Schaltung kostengünstiger und effektiver betrieben werden.

Die zumindest eine Umladeeinheit 3 und der piezoelektrische MEMS-Schallwandler 4 sind ferner in einer Parallelschaltung 5 zueinander angeordnet. Mittels der Parallelschaltung 5 können ein erster Strompfad 6, der vom Energiespeicher 2 durch die zumindest eine Umladeeinheit 3 führt, und ein dritter Strompfad 7, der vom Energiespeicher 2 durch den piezoelektrischen MEMS-Schallwandler 4 führt, unabhängig voneinander mit einem Strom beaufschlagt werden. Die Strompfade 6, 7 sind dabei über eine Masse 11 geschlossen.

Durch die parallele Anordnung der zumindest einen Umladeeinheit 3 und des piezoelektrischen MEMS-Schallwandlers 4 kann in einem ersten Schritt zuerst die Energie auf die Umladeeinheit 3 geladen werden. Durch die Parallelschaltung 5 kann ein Strom auf dem dritten Strompfad 7 verhindert werden. Dadurch wird ein Aufladen des piezoelektrischen MEMS-Schallwandlers 4 in diesem Schritt verhindert. Anschließend kann die auf die Umladeeinheit 3 geladene Energie mittels eines Stromkreises 8 auf den piezoelektrischen MEMS-Schallwandler 4 umgeladen werden. Vorteilhaft dabei ist es, dass der piezoelektrischer MEMS-Schallwandler 4 in mehreren einzelnen Schritten aufgeladen werden kann. Nachdem die Energie von der Umladeeinheit 3 auf den piezoelektrischen MEMS-Schallwandler 4 umgeladen ist, kann in einem zusätzlichen Schritt erneut Energie auf die Umladeeinheit 3 geladen werden, welche dann wieder auf den nun bereits teilweise aufgeladenen piezoelektrischen MEMS-Schallwandler 4 umgeladen wird. Der piezoelektrische MEMS-Schallwandler 4 wird solange mittels Energieportionen aufgeladen, bis eine gewünschte Gesamtenergie auf den piezoelektrischen MEMS-Schallwandler 4 gespeichert ist. Bei Erreichen der Gesamtenergie auf dem piezoelektrischen MEMS-Schallwandler 4 ist eine Endauslenkung des piezoelektrischen MEMS-Schallwandlers 4 erreicht. Da der piezoelektrische MEMS-Schallwandler 4 eine Kapazität aufweist, ist dieser mit einer gewissen Menge an elektrischer Ladung aufgeladen. Der piezoelektrische MEMS-Schallwandler 4 ist damit auf eine gewisse Endspannung aufgeladen.

Dabei ist auch von Vorteil, dass mit der Schaltung aus einer Spannung, die der Energiespeicher 2 bereitstellt, eine höhere Spannung am piezoelektrischen MEMS-Schallwandler 4 erreicht werden kann. Durch das schrittweise Aufladen kann die Spannung des piezoelektrischen MEMS-Schallwandlers 4 schrittweise erhöht werden, bis über die Spannung am Energiespeicher 2 hinaus.

Wenn der piezoelektrische MEMS-Schallwandler 4 auf die Gesamtenergie bzw. Endspannung aufgeladen ist, kann dieser Zustand für eine Zeitspanne gehalten werden, so dass der piezoelektrische MEMS-Schallwandler 4 ausgelenkt bleibt. Erst danach kann die Energie des piezoelektrischen MEMS-Schallwandlers 4 zurückgewonnen werden. Alternativ kann die Energie auch unmittelbar nach Erreichen der Gesamtenergie zurückgewonnen werden.

Um den ersten Strompfad 6 unabhängig vom dem dritten Strompfad 7 mit einem elektrischen Strom zu beaufschlagen, weist die Schaltung 1 im hier gezeigten Ausführungsbeispiel zwei Schalter 9a, 9b sowie eine Schalteinheit 10 auf. Die Schalter 9a, 9b können beispielsweise als Transistoren, insbesondere als Bipolartransistoren und/oder als Feldeffekttransistoren, ausgebildet sein. Die Schalteinheit 10 kann ferner eine Diode und/oder einen weiteren Schalter umfassen. Mittels der Schalteinheit 10 kann der Strom wahlweise nur in einer Richtung durchgeleitet werden, in beide Richtungen durchgeleitet werden oder in beide Richtungen gesperrt werden.

Um einen ersten Schaltzustand auszubilden und in dem ersten Schritt die elektrische Energie vom Energiespeicher 2 auf die zumindest eine Umladeeinheit 3 auf dem ersten Strompfad 6 umzuladen, werden die beiden Schalter 9a und 9b geschlossen, so dass sie den Strom durchleiten. Die Schalteinheit 10 wird dabei derart geschaltet, dass ein Strom durch die Schalteinheit 10 und somit auf dem dritten Strompfad 7 verhindert ist. Das kann beispielsweise mittels einer Diode erreicht werden, die den Strom vom Energiespeicher 2 in den piezoelektrischen MEMS-Schallwandler 4 verhindert. Zusätzlich oder alternativ kann in der Schalteinheit 10 auch ein Schalter angeordnet sein, der geöffnet ist, so dass der dritte Strompfad 7 unterbrochen ist.

Über den Schalter 9a und 9b wird die Energie auf dem ersten Strompfad 6 vom Energiespeicher 2 auf die Umladeeinheit 3 umgeladen. Dabei kann nur ein Bruchteil der gesamten auf den piezoelektrischen MEMS-Schallwandler 4 umzuladende Energie auf die Umladeeinheit 3 umgeladen werden.

Ist die Energie auf die Umladeeinheit 3 umgeladen, wird der Schalter 9a geöffnet, so dass der erste Strompfad 6 unterbrochen ist. Der Schalter 9b bleibt weiterhin geschlossen bzw. leitend. Nun kann der zweite Schaltzustand ausgebildet sein. Die auf die Umladeeinheit 3 umgeladene Energie kann nun im ersten Stromkreis 8 auf den piezoelektrischen MEMS-Schallwandler 4 umgeladen werden. Die Schalteinheit 10 kann dabei derart geschalten werden, dass sie die Energie auf den piezoelektrischen MEMS-Schallwandler 4 in zumindest einer Richtung durchleitet. Die Schalteinheit 10 kann eine Diode umfasse, die die Energie zum piezoelektrischen MEMS-Schallwandler durchlässt. Ist die Energie von der Umladeeinheit 3 auf den piezoelektrischen MEMS-Schallwandler 4 umgeladen, kann beispielsweise der Schalter 9b geöffnet werden, so dass der Stromkreis 8 unterbrochen wird. Zusätzlich oder alternativ kann auch in der Schalteinheit 10 eine Diode angeordnet sein, so dass zwar die Energie auf den piezoelektrischen MEMS-Schallwandler 4 umgeladen werden kann, jedoch ein Zurückladen der Energie vom piezoelektrischen MEMS-Schallwandler 4 auf die erste Umladeeinheit 3 verhindert ist.

Dieser Umladevorgang von Energie vom Energiespeicher 2 auf den piezoelektrischen MEMS-Schallwandler 4 kann wiederholt werden, bis die Gesamtenergie bzw. eine Gesamtladung auf dem piezoelektrischen MEMS-Schallwandler 4 erreicht ist. Die Energie bzw. die Ladung wird dabei schrittweise bzw. in Portionen auf dem piezoelektrischen MEMS-Schallwandler 4 erhöht. Dadurch wird eine Verlustleistung in der Schaltung 1 verringert. Dies führt zu weniger Abwärme, so dass die Schaltung 1 kompakter und effektiver ausgebildet werden kann.

Um in einem dritten Schaltzustand die Energie von dem piezoelektrischen MEMS-Schallwandler 4 zurückzugewinnen, kann der Schalter 9b geschlossen werden. Der Schalter 9a ist geöffnet, so dass ein Strom in den Energiespeicher 2 verhindert ist. Außerdem kann die Schalteinheit 10 die elektrische Energie vom piezoelektrischen MEMS-Schallwandler 4 zur Umladeeinheit 3 durchleiten. Dadurch wird die Energie wieder vom piezoelektrischen MEMS-Schallwandler 4 in dem ersten Stromkreis 8 auf die Umladeeinheit 3 umgeladen. Ist die Energie auf der Umladeeinheit 3 geladen, kann beispielsweise ein in der Schalteinheit 10 angeordneter Schalter geöffnet werden, so dass ein Rückfluss der Energie in den piezoelektrischen MEMS-Schallwandler 4 verhindert ist. Der Rückfluss der Energie kann aber auch mittels einer Diode in der Schalteinheit 10 erreicht werden.

In einem vierten Schaltzustand kann die in der Umladeeinheit 3 gespeicherte Energie auf den Energiespeicher 2 geladen werden. Dazu wird der Schalter 9a geschlossen, so dass der erste Strompfad 6 leitend wird. Der Schalter 9b ist ebenfalls geschlossen. Die Energie wird damit wieder auf den Energiespeicher 2 zurückgeladen.

Zur Energierückgewinnung können der dritte und der vierte Schaltzustand wiederholt werden, bis die vollständige Energie in den Energiespeicher 2 zurückgeladen ist.

Um Energieverluste in der Schaltung 1 auszugleichen, weist sie eine Energieversorgung 12 auf, mittels der die Energieverluste ausgleichbar sind. In diesem Ausführungsbeispiel kann die Energieversorgung 12 die Energie in dem Energiespeicher 2 erhöhen, so dass die Energieverluste ausgeglichen sind.

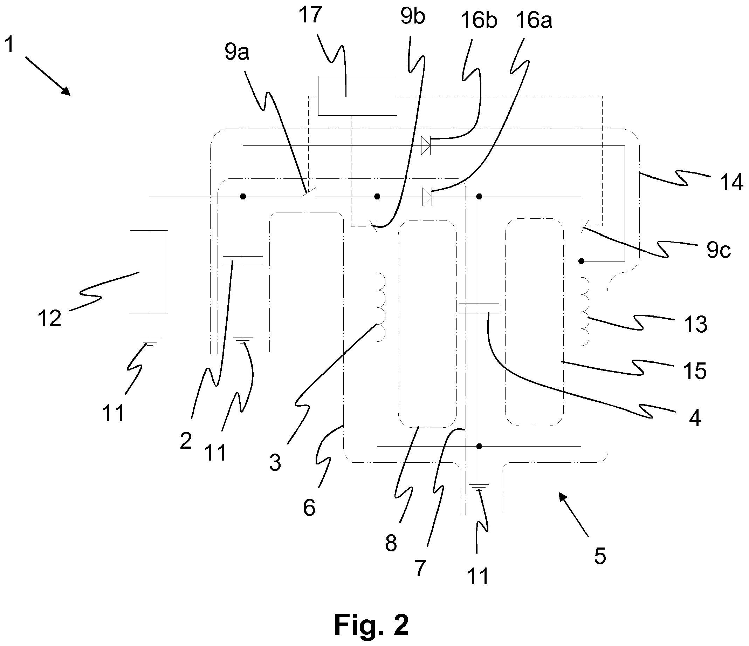

Figur 2 zeigt ein Blockschaltbild einer alternativen Schaltung 1 zum Betreiben eines als piezoelektrischer MEMS-Schallwandlers 4 ausgebildeten Piezo-Bauteils. Die Schaltung 1 umfasst das als piezoelektrischer MEMS-Schallwandler 4 ausgebildete Piezo-Bauteil, einen Energiespeicher 2, eine erste Umladeeinheit 3 und einer zweiten Umladeeinheit 13.

Neben der ersten Umladeeinheit 3, die in einer Parallelschaltung 5 zum piezoelektrischen MEMS-Schallwandler 4 angeordnet ist, weist die Schaltung 1 die zweite Umladeeinheit 13 auf. Die zweite Umladeeinheit 13 ist ebenfalls zum piezoelektrischen MEMS-Schallwandler 4 in einer Parallelschaltung 5 angeordnet. Des Weiteren ist die zweiten Umladeeinheit 13 zu der ersten Umladeeinheit 3 parallel angeordnet. Durch die parallele Anordnung der beiden Umladeeinheiten 3, 13 und des piezoelektrischen MEMS-Schallwandlers 4, können die jeweiligen Bauteile 3, 4, 13 unabhängig voneinander mit einem Strom beaufschlagt werden. Von dem Energiespeicher 2 zur zweiten Umladeeinheit 13 führt dabei ein zweiter Strompfad 14. Beispielsweise kann der erste Strompfad 6 durch die erste Umladeeinheit 3 unabhängig von dem zweiten Strompfad 14 durch die zweite Umladeeinheit 13 mit Strom beaufschlagt werden. Dadurch kann das Betreiben des piezoelektrischen MEMS-Schallwandlers 4 flexibler durchgeführt werden.

Ferner umfassen die erste Umladeeinheit 3 und die zweite Umladeeinheit 13 eine Spule mit einer Induktivität. Dadurch kann in den Umladeeinheiten 3, 13 die elektrische Energie in Form eines magnetischen Feldes zumindest zeitweise gespeichert werden.

Zusätzlich umfasst der Energiespeicher 2 einen Kondensator mit einer Kapazität, in dem die elektrische Energie in Form eines elektrischen Feldes gespeichert werden kann.

Der piezoelektrische MEMS-Schallwandler 4 ist in dieser Figur 2 als Kondensator dargestellt, da der piezoelektrische MEMS-Schallwandler 4 im Wesentlichen die elektrischen Eigenschaften eines Kondensators aufweist.

Der Kondensator des Energiespeichers 2 sowie die Kapazität des piezoelektrischen MEMS-Schallwandlers 4 und die Spule der Umladeeinheiten 3, 13 bildet zueinander (natürlich nur jeweils die Paare Kondensator-Spule) jeweils einen elektrischen Schwingkreis, bei dem die Energie zwischen den Bauteilen zu schwingen vermag.

Zum Betreiben des piezoelektrischen MEMS-Schallwandlers 4 soll nun die in dem Energiespeicher 2 gespeicherte Energie schrittweise auf den piezoelektrischen MEMS-Schallwandler 4 umgeladen werden. Da der Energiespeicher 2 als Kondensator ausgebildet ist, weist dieser, wenn darin eine elektrische Energie gespeichert ist, eine Spannung auf. Mittels Schließens der Schalter 9a, 9b (alle Schalter 9a-9c sind zu Beginn geöffnet) kann die Spannung des Energiespeichers 2 in dem ersten Strompfad 6 einen Strom hervorrufen. Der erste Schaltzustand ist ausgebildet. In der Schaltung 1 ist des Weiteren eine Diode 16a angeordnet, die einen Strom auf dem dritten Strompfad 7 durch den piezoelektrischen MEMS-Schallwandler 4 oder durch die zweite Umladeeinheit 13 verhindert. Dies ist ein Vorteil der Parallelschaltung 5, wodurch lediglich der erste Strompfad 6 unabhängig von den anderen mit einem Strom beaufschlagbar ist.

Da der Energiespeicher 2 einen Kondensator und die zumindest eine erste Umladeeinheit 3 eine Spule aufweist, bilden sie einen elektrischen Schwingkreis, so dass die elektrische Energie im ersten Strompfad 6 zwischen dem Energiespeicher 2 und der ersten Umladeeinheit 3 schwingt. Der Schwingkreis bildet außerdem einen resonanten Schwingkreis.

Wenn die elektrische Energie vom Energiespeicher 2 auf die Umladeeinheit 3 umgeladen ist, wobei sie in der Spule in dem magnetischen Feld gespeichert ist, wird der Schalter 9a geöffnet. Dadurch wird der Schwingkreis unterbrochen, so dass keine Energie zwischen dem Energiespeicher 2 und der ersten Umladeeinheit 3 umgeladen werden kann. Der Schalter 9b bleibt dabei weiterhin geschlossen. Nun ist der zweite Schaltzustand ausgebildet.

Da der Schalter 9b weiterhin geschlossen ist, ist der Stromkreis 8 geschlossen, so dass die in der ersten Umladeeinheit 3 bzw. in der Spule gespeicherte Energie auf den piezoelektrischen MEMS-Schallwandler 4 umgeladen werden kann. Dabei bildet die Spule der ersten Umladeeinheit 3 und die Kapazität des piezoelektrischen MEMS-Schallwandlers 4 ebenfalls einen elektrischen, insbesondere resonanten, Schwingkreis aus. Die Energie wird somit von der Spule mittels eines Stroms in dem ersten Stromkreis 8 auf den piezoelektrischen MEMS-Schallwandler 4 übertragen. Die Diode 16a ist dabei derart orientiert angeordnet, dass ein Strom von der Umladeeinheit 3 auf den piezoelektrischen MEMS-Schallwandler 4 durchgelassen wird, jedoch ein Strom von dem piezoelektrischen MEMS-Schallwandler 4 zurück auf die Umladeeinheit 3 blockiert ist. Die Energie bleibt somit in dem piezoelektrischen MEMS-Schallwandler 4 gespeichert, wobei sich der piezoelektrische MEMS-Schallwandler 4, bzw. dessen Aktor sowie die mit diesem gekoppelte Membran, auslenkt.

Dabei kann nur ein Bruchteil einer für den Betrieb des piezoelektrischen MEMS-Schallwandlers 4 benötigten Gesamtenergie mittels des genannten Verfahrens auf den piezoelektrischen MEMS-Schallwandler 4 umgeladen werden. Beispielsweise ist nur 1/1000 der Gesamtenergie auf den piezoelektrischen MEMS-Schallwandler 4 übertragen worden.

Ein Vorteil der Parallelschaltung 5 ist es, dass in einem weiteren Schritt durch erneutes Schließen des Schalters 9a nochmals Energie von dem Energiespeicher 2 auf die erste Umladeeinheit 3 übertragen wird. Der erste Schaltzustand wird dabei wieder hergestellt. Es findet hier jedoch noch keine Energieübertragung auf den piezoelektrischen MEMS-Schallwandler 4 statt. Wenn die Energie auf der ersten Umladeeinheit 3 übertragen ist, wird der Schalter 9a geöffnet, so dass die in der ersten Umladeeinheit 3 gespeicherte Energie auf den piezoelektrischen MEMS-Schallwandler 4 übertragen wird. Die Schaltung 1 befindet sich nun wieder im zweiten Schaltzustand. Im piezoelektrischen MEMS-Schallwandler 4 befinden sich nun beispielsweise zwei Bruchteile (beispielsweise 2 mal 1/1000) der Gesamtenergie. Alternativ kann auch die doppelte Ladungsmenge auf dem piezoelektrischen MEMS-Schallwandler 4 angeordnet sein.

Dieser Vorgang kann solange durchgeführt werden, bis die Gesamtenergie auf den piezoelektrischen MEMS-Schallwandler 4 übertragen ist und eine gewünschte Auslenkung des piezoelektrischen MEMS-Schallwandlers 4 erreicht ist.

Um die in dem piezoelektrischen MEMS-Schallwandler 4 gespeicherte Energie zurückzugewinnen, so dass die Schaltung 1 kostengünstiger und effektiver betrieben werden kann, kann in diesem Ausführungsbeispiel die Energie nach dem Auslenken des piezoelektrischen MEMS-Schallwandlers 4 mittels der zweiten Umladeeinheit 13 auf den Energiespeicher 2 umgeladen werden. In der zweiten Umladeeinheit 13 ist in diesem Ausführungsbeispiel ebenfalls eine Spule angeordnet, so dass der piezoelektrische MEMS-Schallwandler 4 und die zweite Umladeeinheit 13 ebenfalls einen, insbesondere resonanten, Schwingkreis ausbilden. Mittels Schließens des Schalters 9c wird der zweite Stromkreis 15 geschlossen, so dass die Energie vom piezoelektrischen MEMS-Schallwandler 4 zur zweiten Umladeeinheit 13 umgeladen wird. Nun ist ein siebter Schaltzustand ausgebildet. Der Schalter 9b kann geöffnet sein, so dass der erste Stromkreis 8 unterbrochen ist, um ein Umladen der Energie auf die erste Umladeeinheit 3 zu verhindern. Zusätzlich oder alternativ kann auch die Diode 16a den Strom in die erste Umladeeinheit 3 verhindern.

Wenn die Energie auf die zweite Umladeeinheit 13 umgeladen ist, wird der Schalter 9c geöffnet, so dass die Energie über den zweiten Strompfad 14 zurück auf den Energiespeicher 2 übertragen wird. Nun ist ein achter Schaltzustand ausgebildet. Der Vorgang des Energierückgewinnens kann dabei ebenfalls in einer Vielzahl an Schritten durchgeführt werden, so dass jeweils nur ein Bruchteil der Gesamtenergie des piezoelektrischen MEMS-Schallwandlers 4 auf den Energiespeicher 2 umgeladen wird.

Anzumerken ist hier die Nummerierung der Schaltzustände. Beispielsweise beschreibt der siebte Schaltzustand lediglich, dass die Energie von dem piezoelektrischen MEMS-Schallwandler 4 auf die zweite Umladeeinheit 13 übertragen wird. Die Nummerierung wurde lediglich gewählt, um den Schaltzustand, in dem die Energie vom piezoelektrischen MEMS-Schallwandler 4 auf die erste Umladeeinheit 2 übertragen wird, von dem Schaltzustand zu unterscheiden, in dem die Energie vom piezoelektrischen MEMS-Schallwandler 4 auf die zweite Umladeeinheit 13 übertragen wird. Der siebte Schaltzustand bedeutet hier nicht, dass sechs andere Schaltzustände realisiert werden müssen.

Um die Schalter 9a-9c zu schalten, weist die Schaltung 1 eine Steuerung 17 auf, mittels der die Schalter 9a-9c schaltbar sind.

Mittels der Steuerung 17 und dem Schalten der Schalter 9a-9c können auch die gewünschten Schallwellen erzeugt werden. Beispielsweise soll ein Ton mit einer Frequenz von 1000 Hz erzeugt werden. Somit ist eine Periode des Tons 1 ms (1/1000 Hz) lang. Das heißt, dass der piezoelektrische MEMS-Schallwandler 4 innerhalb von beispielweise 0,5 ms aufgeladen werden soll. Die restlichen 0,5 ms können für die Energierückgewinnung verwendet werden. Soll des Weiteren der piezoelektrische MEMS-Schallwandler 4 mittels 1000 Aufladeschritten aufgeladen werden, dauert ein Aufladeschritt 0,5 µs, oder 500 ns. Das heißt wiederum, dass die Steuerung 17 die Schalter 9a-c mit einer Frequenz von 2 MHz schalten muss. Die Steuerung 17 kann die Schalter 9a-c auch noch schneller schalten, wenn beispielsweise mehr Aufladeschritte durchgeführt und/oder ein Ton mit einer höheren Frequenz erzeugt werden soll. Die Steuerung kann die Schalter beispielsweise mit einer Frequenz von 500 MHz ansteuern.

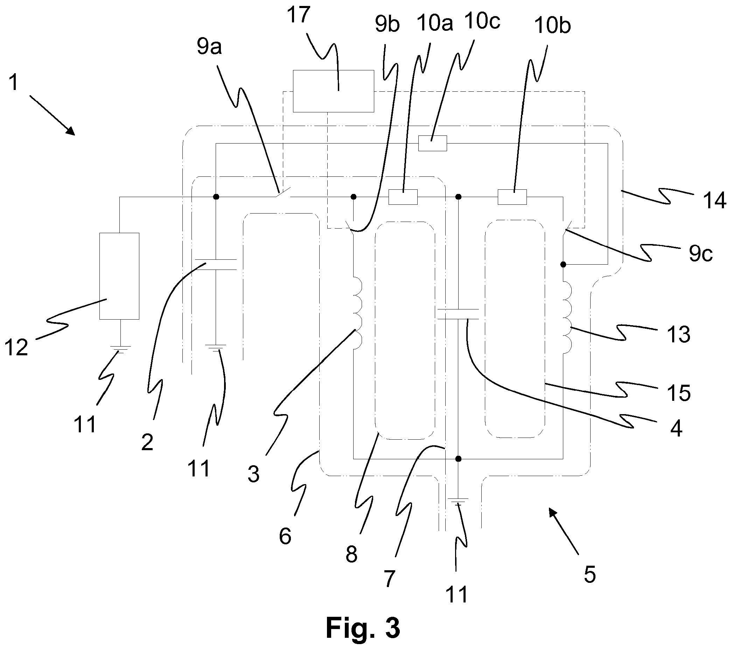

Figur 3 zeigt ein Blockschaltbild einer alternativen Schaltung 1 zum Betreiben eines als piezoelektrische MEMS-Schallwandler 4 ausgebildeten Piezo-Bauteils. Neben dem piezoelektrischen MEMS-Schallwandler 4 umfasst die Schaltung des Weiteren einen Energiespeicher 2 und zwei Umladeeinheiten 3, 13.

Das Betreiben des piezoelektrischen MEMS-Schallwandlers 4 kann hier parallel mit beiden Umladeeinheiten 3, 13 durchgeführt werden. Beispielsweise kann zuerst im ersten Schaltzustand die Energie vom Energiespeicher 2 auf die erste Umladeeinheit 3 übertragen werden, wozu die beiden Schalter 9a, 9b geschlossen sind. Nach dem Öffnen des Schalters 9b im zweiten Schaltzustand kann die Energie in dem ersten Stromkreis 8 von der ersten Umladeeinheit 3 auf den piezoelektrischen MEMS-Schallwandler 4 übertragen werden. In dem ersten Stromkreis 8 ist eine Schalteinheit 10a angeordnet, die beispielsweise eine Diode umfassen kann, mittels der der Rückfluss von Energie aus dem piezoelektrischen MEMS-Schallwandler 4 zur ersten Umladeeinheit 3 verhindert werden kann. Außerdem kann die Schalteinheit 10a auch zumindest einen Schalter umfassen, so dass der ersten Stromkreis 8 unterbrochen werden kann. Mittels der Schalteinheit 10a kann auch ein Strom in beide Richtungen durchgeleitet werden.

Von Vorteil ist es, wenn während die Energie von der ersten Umladeeinheit 3 auf den piezoelektrischen MEMS-Schallwandler 4 umgeladen wird, elektrische Energie in einem fünften Schaltzustand vom Energiespeicher 2 auf die zweite Umladeeinheit 13 umgeladen wird. Die Energie fließt dabei über den zweiten Strompfad 14 zur zweiten Umladeeinheit 13. Der zweite Strompfad 14 weist eine Schalteinheit 10c auf, die eine Diode und/oder zumindest einen Schalter umfassen kann, so dass der Strom in beide Richtungen, in nur einer Richtung und/oder in keiner Richtung fließen kann. Die Schalteinheit 10c wird dabei derart geschalten, dass wenn die Energie auf die zweite Umladeeinheit 13 geladen ist, ein Rückfluss der Energie zum Energiespeicher 2 verhindert ist. Wenn auf die zweite Umladeeinheit 13 Energie geladen ist, kann diese von dort in einem sechsten Schaltzustand über den zweiten Stromkreis 15 auf den piezoelektrischen MEMS-Schallwandler 4 übertragen werden. In dem zweiten Stromkreis 15 ist die Schalteinheit 10b angeordnet, die beispielsweise eine Diode und/oder zumindest einen Schalter umfassen kann, mittels denen der Rückfluss von Energie aus dem piezoelektrischen MEMS-Schallwandler 4 zur zweiten Umladeeinheit 3 verhindert werden kann. Mittels der Schalteinheit 10b kann der Strom auch in beide Richtungen durchgeleitet und/oder der Strom in beide Richtungen gesperrt werden. Das Umladen von Energie von der zweiten Umladeeinheit 13 auf den piezoelektrischen MEMS-Schallwandler 4 im sechsten Schaltzustand kann beispielsweise dann durchgeführt werden, während im ersten Schaltzustand auf die erste Umladeeinheit 3 Energie vom Energiespeicher 2 übertragen wird. Zusätzlich oder alternativ können auch im ersten Schaltzustand auf die erste Umladeeinheit 3 und im fünften Schaltzustand die zweite Umladeeinheit 13 gleichzeitig Energie vom Energiespeicher 2 umgeladen werden. Ebenfalls zusätzlich oder alternativ können auch die erste Umladeeinheit 3 und die zweite Umladeeinheit 13 die Energie gleichzeitig auf den piezoelektrischen MEMS-Schallwandler 4 übertragen. Durch ein paralleles und/oder zeitlich versetztes Umladen der Energien auf die beiden Umladeeinheiten 3, 13 sowie auf den piezoelektrischen MEMS-Schallwandler 4 kann das Umladen schneller durchgeführt werden.

Zusätzlich oder alternativ kann das parallele und/oder zeitlich versetzte Umladen der Energie auch für die Energierückgewinnung durchgeführt werden. Beispielsweise kann die Energie vom piezoelektrischen MEMS-Schallwandler 4 in beide Umladeeinheiten 3, 13 umgeladen werden. Von den beiden Umladeeinheiten 3, 13 kann dann gleichzeitig die Energie in den Energiespeicher 2 geladen werden. Die Energierückgewinnung kann damit ebenfalls schneller durchgeführt werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Schaltung
- 2: Energiespeicher
- 3: erste Umladeeinheit
- 4: piezoelektrischer MEMS-Schallwandler
- 5: Parallelschaltung
- 6: erster Strom pfad
- 7: dritter Strompfad
- 8: erster Stromkreis
- 9: Schalter
- 10: Schalteinheit
- 11: Masse
- 12: Energieversorgung
- 13: zweite Umladeeinheit
- 14: zweiter Strompfad
- 15: zweiter Stromkreis
- 16: Diode
- 17: Steuerung

## Patentansprüche

1. Verfahren zum Betreiben eines piezoelektrischen MEMS-Schallwandlers (4), insbesondere eines im hörbaren Wellenlängenspektrum und/oder im Ultraschallbereich arbeitenden MEMS-Lautsprechers, bei dem in zumindest einem Energiespeicher (2) elektrische Energie gespeichert wird und diese elektrische Energie zwischen dem Energiespeicher (2) und dem piezoelektrischen MEMS-Schallwandler (4) mittelbar über zumindest eine erste Umladeeinheit (3, 13) umgeladen wird,
wobei zumindest die erste Umladeeinheit (3, 13) und der piezoelektrische MEMS-Schallwandler (4) zueinander in einer Parallelschaltung (5) angeordnet sind und Schalteinheiten (10) und/oder Schalter (9) von einer Steuerung (17) derart geschalten werden,
dass zum Betreiben des piezoelektrischen MEMS-Schallwandlers (4) in einem ersten Schaltzustand zunächst zumindest die erste Umladeeinheit (3) vom Energiespeicher (2) geladen wird,
dass anschließend in einem zweiten Schaltzustand diese erste Umladeeinheit (3) wieder entladen und der piezoelektrische MEMS-Schallwandler (4) hierbei geladen wird,
dass zur Energierückgewinnung in einem dritten Schaltzustand der piezoelektrische MEMS-Schallwandler (4) wieder entladen und zumindest die erste Umladeeinheit (3, 13) hierbei geladen wird und
dass anschließend in einem vierten Schaltzustand diese erste Umladeeinheit (3, 13) wieder entladen und der Energiespeicher (2) hierbei geladen wird,
**dadurch gekennzeichnet,**
**dass** die elektrische Energie schrittweise zwischen dem Energiespeieher (2) und dem piezoelektrischen MEMS-Schallwandler (4) umgeladen wird, so dass die elektrische Energie jeweils zum Aufladen und zur Energierückgewinnung in mehreren Portionen umgeladen wird.

2. Verfahren nach dem vorherigen Anspruch, **dadurch gekennzeichnet, dass** zum Betreiben des piezoelektrischen MEMS-Schallwandlers (4) die elektrische Energie vom Energiespeicher (2) im ersten Schaltzustand zuerst auf einem ersten Strompfad (6) zumindest teilweise auf die erste Umladeeinheit (3) geladen wird und
anschließend die elektrische Energie im zweiten Schaltzustand in einem ersten Stromkreis (8) von der ersten Umladeeinheit (3) auf den piezoelektrischen MEMS-Schallwandler (4) zumindest teilweise umgeladen wird und
dass zur Energierückgewinnung die elektrische Energie des piezoelektrischen MEMS-Schallwandlers (4) im dritten Schaltzustand zuerst in dem ersten Stromkreis (8) von dem piezoelektrischen MEMS-Schallwandler (4) auf die erste Umladeeinheit (3) geladen wird und anschließend im vierten Schaltzustand auf dem ersten Strompfad (6) auf den Energiespeicher (2) übertragen wird.

3. Verfahren nach einem der vorherigen Ansprüche, **dadurch gekennzeichnet, dass** bei dem Verfahren mittels einer zweiten Umladeeinheit (13) die elektrische Energie zwischen dem Energiespeicher (2) und dem piezoelektrischen MEMS-Schallwandler (4) umgeladen wird und dass zum Betreiben des piezoelektrischen MEMS-Schallwandlers (4) die elektrische Energie vom Energiespeicher (2) in einem fünften Schaltzustand zuerst auf zumindest einem zweiten Strompfad (14) zumindest teilweise auf die zweite Umladeeinheit (13) geladen wird und anschließend die elektrische Energie in einem sechsten Schaltzustand in einem zweiten Stromkreis (15) von der zweiten Umladeeinheit (13) auf den piezoelektrischen MEMS-Schallwandler (4) zumindest teilweise geladen wird und
dass zur Energierückgewinnung die elektrische Energie des piezoelektrischen MEMS-Schallwandlers (4) in einem siebten Schaltzustand zuerst in dem zweiten Stromkreis (15) von dem piezoelektrischen MEMS-Schallwandler (4) auf die zweite Umladeeinheit (13) geladen wird und anschließend in einem achten Schaltzustand auf dem zweiten Strompfad (14) auf den Energiespeicher (2) übertragen wird.

4. Verfahren nach den vorherigen Ansprüchen 2 und 3, **dadurch gekennzeichnet, dass** während des Umladens der elektrischen Energie in dem ersten Stromkreis (8) von der ersten Umladeeinheit (3) auf den piezoelektrischen MEMS-Schallwandler (4) elektrische Energie auf dem zweiten Strompfad (14) von dem Energiespeicher (2) auf die zweite Umladeeinheit (13) übertragen wird und
dass während des Umladens der elektrischen Energie in dem zweiten Stromkreis (15) von der zweiten Umladeeinheit (13) auf den piezoelektrischen MEMS-Schallwandler (4) elektrische Energie auf dem ersten Strompfad (6) von dem Energiespeicher (2) auf die erste Umladeeinheit (3) übertragen wird.

5. Verfahren nach den vorherigen Ansprüchen 2 bis 4, **dadurch gekennzeichnet, dass** die Schaltung (1) eine Vielzahl an Schalteinheiten (10) und/oder Schalter (9) umfasst, die derart geöffnet und/oder geschlossen werden, und/oder eine Vielzahl an Dioden (16) umfasst, die derart angeordnet sind, dass die verschiedenen Schaltzustände ausgebildet werden können, wobei der erste Strompfad (6), der zweite Strompfad (14), der erste Stromkreis (8) und/oder der zweite Stromkreis (15) unterbrochen und/oder leitend werden bzw. sind, so dass die elektrische Energie zwischen dem Energiespeicher (2), der ersten Umladeeinheit (3), der zweiten Umladeeinheit (13) und/oder dem piezoelektrischen MEMS-Schallwandler (4) umgeladen werden kann.

6. Verfahren nach den vorherigen Ansprüchen 1 bis 4, **dadurch gekennzeichnet, dass** der Energiespeicher (2), die erste Umladeeinheit (3), die zweite Umladeeinheit (13) und/oder der piezoelektrische MEMS-Schallwandler (4) einen elektrischen, insbesondere resonanten, Schwingkreis ausbilden, wobei die Schalter (9) und/oder Schalteinheiten (10) vorzugsweise derart geschalten werden, dass in einem Stromnulldurchgang des jeweiligen Schwingkreises geschalten wird.

7. Schaltung mit
Schalteinheiten (10) und/oder Schaltern (9),
einer Steuerung (17) zum Schalten der Schalteinheiten (10) und/oder Schalter (9),
zumindest einem Energiespeicher (2), in dem elektrische Energie speicherbar ist,
einem piezoelektrischen MEMS-Schallwandler (4), insbesondere einem im hörbaren Wellenlängenspektrum und/oder im Ultraschallbereich arbeitenden MEMS-Lautsprecher, und
zumindest einer ersten Umladeeinheit (3, 13), mittels der die elektrische Energie zwischen dem Energiespeicher (2) und dem piezoelektrischen MEMS-Schallwandler (4) umladbar ist,
wobei zumindest die erste Umladeeinheit (3, 13) und der piezoelektrische MEMS-Schallwandler (4) in einer Parallelschaltung (5) zueinander angeordnet sind und
wobei mittels der Steuerung (17) die Schaltung (1) derart betrieben wird,
dass zum Betreiben des piezoelektrischen MEMS-Schallwandlers (4) in einem ersten Schaltzustand zunächst zumindest die erste Umladeeinheit (3) vom Energiespeicher (2) geladen wird,
dass anschließend in einem zweiten Schaltzustand diese erste Umladeeinheit (3) wieder entladen und der piezoelektrische MEMS-Schallwandler (4) hierbei geladen wird,
dass zur Energierückgewinnung in einem dritten Schaltzustand der piezoelektrische MEMS-Schallwandler (4) wieder entladen und zumindest die erste Umladeeinheit (3, 13) hierbei geladen wird und
dass anschließend in einem vierten Schaltzustand diese erste Umladeeinheit (3, 13) wieder entladen und der Energiespeicher (2) hierbei geladen wird,
**dadurch gekennzeichnet,**
**dass** die elektrische Energie schrittweise zwischen dem Energiespeicher (2) und dem piezoelektrischen MEMS-Schallwandler (4) umgeladen wird, so dass die elektrische Energie jeweils zum Aufladen und zur Energierückgewinnung in mehreren Portionen umgeladen wird.

8. Schaltung nach dem vorherigen Anspruch, **dadurch gekennzeichnet, dass** die Schaltung (1) die erste Umladeeinheit (3) umfasst, wobei durch die erste Umladeeinheit (3) ein erster Strompfad (6) verläuft.

9. Schaltung nach Anspruch 8, **dadurch gekennzeichnet, dass** die Schaltung (1) eine zweite Umladeeinheit (13) umfasst, wobei durch die zweite Umladeeinheit (13) ein zweiter Strompfad (14) verläuft.

10. Schaltung nach den Ansprüchen 8 und 9, **dadurch gekennzeichnet, dass** die erste Umladeeinheit (3) und die zweite Umladeeinheit (13) in einer Parallelschaltung (5) angeordnet sind, so dass der erste Strompfad (6) und der zweite Strompfad (14) unabhängig voneinander mit Strom beaufschlagbar sind.

11. Schaltung nach einem oder mehreren der vorherigen Ansprüche 8 - 10, **dadurch gekennzeichnet, dass** die erste Umladeeinheit (3) und der piezoelektrische MEMS-Schallwandler (4) derart zueinander angeordnet sind, dass ein erster Stromkreis (8) ausgebildet ist, und
dass die zweite Umladeeinheit (13) und der piezoelektrische MEMS-Schallwandler (4) derart zueinander angeordnet sind, dass ein zweiter Stromkreis (15) ausgebildet ist.

12. Schaltung nach einem oder mehreren der vorherigen Ansprüche 8 - 11, **dadurch gekennzeichnet, dass** die erste Umladeeinheit (3) und/oder die zweite Umladeeinheit (13) eine Energiespeichereinheit, insbesondere eine Spule mit einer Induktivität, umfasst, so dass in den Umladeeinheiten (3, 13) die elektrische Energie speicherbar ist, und/oder dass der Energiespeicher (2) einen Kondensator mit einer Kapazität umfasst, so dass darin die elektrische Energie speicherbar ist, und/oder dass der Energiespeicher (2), die erste Umladeeinheit (3), die zweite Umladeeinheit (13) und/oder der piezoelektrische MEMS-Schallwandler (4) einen elektrischen, insbesondere resonanten, Schwingkreis ausbilden, so dass die in dem elektrischen Schwingkreis gespeicherte elektrische Energie zwischen den jeweiligen Bauteilen zu schwingen vermag.

13. Schaltung nach einem oder mehreren der vorherigen Ansprüche 8 - 12, **dadurch gekennzeichnet, dass** die Schaltung (1) eine Steuerung (17) und eine Vielzahl an Schalteinheiten (10) und/oder Schalter (9), insbesondere Transistoren, und/oder Dioden (16) aufweist, so dass die jeweiligen Schaltzustände ausbildbar sind, wobei die Schalteinheiten (10) und/oder Schalter (9) derart mittels der Steuerung (17) ansteuerbar sind, dass der erste Strompfad (6), der zweite Strompfad (14), der erste Stromkreis (8) und/oder der zweite Stromkreis (15) unterbrechbar und/oder leitbar ist, so dass ein elektrischer Strom in den jeweiligen Strompfaden (6, 7, 14) und/oder Stromkreisen (8, 15) unterbrechbar und/oder leitbar ist.

14. Integrierter Schaltkreis, insbesondere einen ASIC, der eine Schaltung (1) umfasst, die nach zumindest einem oder mehreren der vorherigen Ansprüche 7 - 13 ausgebildet ist.

## Claims

1. A method for operating a piezoelectric MEMS sound transducer (4), in particular a MEMS loudspeaker operating in the audible wavelength spectrum and/or in the ultrasonic range,
in which electrical energy is stored in at least one energy store (2) and this electrical energy is transferred between the energy store (2) and the piezoelectric MEMS sound transducer (4) indirectly via at least one first transfer unit (3, 13),
wherein at least the one first transfer unit (3, 13) and the piezoelectric MEMS sound transducer (4) are situated in a parallel circuit (5) with respect to one another and switching units (10) and/or switches (9) are switched in such a way by a controller (17),
that, in order to operate the piezoelectric MEMS sound transducer (4) in a first switching state, at least the first transfer unit (3) is first of all charged from the energy store (2),
that this first transfer unit (3) is then discharged again in a second switching state and the piezoelectric MEMS sound transducer (4) is charged in this case,
that in order to recover energy in a third switching state, the piezoelectric MEMS sound transducer (4) is discharged again and at least the first transfer unit (3, 13) is charged in this case, and
that this first transfer unit (3, 13) is then discharged again in a fourth switching state and the energy store (2) is charged in this case, **characterized in that**,
the electrical energy is transferred step-by-step between the energy store (2) and the piezoelectric MEMS sound transducer (4), so that the electrical energy is transferred in multiple portions for both charging and energy recovery, respectively.

2. The method as claimed in the preceding claim, **characterized in that**, in order to operate the piezoelectric MEMS sound transducer (4), the electrical energy is first of all at least partially transferred from the energy store (2), on a first current path (6), to the first transfer unit (3), in the first switching state, and
the electrical energy is then at least partially transferred, in a first circuit (8), from the first transfer unit (3) to the piezoelectric MEMS sound transducer (4), in the second switching state, and,
that in order to recover energy, the electrical energy of the piezoelectric MEMS sound transducer (4) is first of all transferred, in the first circuit (8), from the piezoelectric MEMS sound transducer (4) to the first transfer unit (3), in the third switching state, and is then transferred, on the first current path (6), to the energy store (2), in the fourth switching state.

3. The method as claimed in one of the preceding claims, **characterized in that**, in the method, the electrical energy is transferred between the energy store (2) and the piezoelectric MEMS sound transducer (4) with the aid of a second transfer unit (13) and, that in order to operate the piezoelectric MEMS sound transducer (4), the electrical energy is first of all at least partially transferred from the energy store (2), on at least one second current path (14), to the second transfer unit (13), in a fifth switching state, and the electrical energy is then at least partially transferred, in a second circuit (15), from the second transfer unit (13) to the piezoelectric MEMS sound transducer (4), in a sixth switching state, and
that in order to recover energy, the electrical energy of the piezoelectric MEMS sound transducer (4) is first of all transferred, in the second circuit (15), from the piezoelectric MEMS sound transducer (4) to the second transfer unit (13), in a seventh switching state, and is then transferred, on the second current path (14), to the energy store (2), in an eighth switching state.

4. The method as claimed in the preceding claims 2 and 3, **characterized in that** electrical energy is transferred, on the second current path (14), from the energy store (2) to the second transfer unit (13) during the transfer of the electrical energy, in the first circuit (8), from the first transfer unit (3) to the piezoelectric MEMS sound transducer (4) and electrical energy is transferred, on the first current path (6), from the energy store (2) to the first transfer unit (3) during the transfer of the electrical energy, in the second circuit (15), from the second transfer unit (13) to the piezoelectric MEMS sound transducer (4).

5. The method as claimed in the preceding claims 2 to 4, **characterized in that** the circuit (1) comprises a plurality of switching units (10) and/or switches (9) which are opened and/or closed in such a way, and/or comprises a plurality of diodes (16), which are situated in such a way, that the various switching states can be formed, wherein the first current path (6), the second current path (14), the first circuit (8), and/or the second circuit (15) are/is interrupted and/or made to be conductive or are/is conductive, so the electrical energy can be transferred between the energy store (2), the first transfer unit (3), the second transfer unit (13), and/or the piezoelectric MEMS sound transducer (4).

6. The method as claimed in the preceding claims 1 to 4, **characterized in that** the energy store (2), the first transfer unit (3), the second transfer unit (13), and/or the piezoelectric MEMS sound transducer (4) form an electrical, in particular resonant, oscillating circuit, wherein the switches (9) and/or switching units (10) are preferably switched in such a way that the switching takes place in a current zero crossing of the particular oscillating circuit.

7. A circuit comprising
switching units (10) and/or switches (9),
a controller (17) for switching the switching units (10) and/or switches (9),
at least one energy store (2), in which electrical energy can be stored, a piezoelectric MEMS sound transducer (4), in particular a MEMS loudspeaker operating in the audible wavelength spectrum and/or in the ultrasonic range, and
at least one first transfer unit (3, 13), with the aid of which the electrical energy can be transferred between the energy store (2) and the piezoelectric MEMS sound transducer (4),
wherein at least the first_transfer unit (3, 13) and the piezoelectric MEMS sound transducer (4) are situated in a parallel circuit (5) with respect to one another and
wherein the circuit (1) is operated in such a way by means of the control (17),
that for operating the piezoelectric MEMS sound transducer (4) in a first switching state, at least the first transfer unit (3) is first of all charged from the energy store (2),
that this first transfer unit (3) is then discharged again in a second switching state and the piezoelectric MEMS sound transducer (4) is charged in this case,
that in order to recover energy in a third switching state, the piezoelectric MEMS sound transducer (4) is discharged again and at least the first transfer unit (3, 13) is charged in this case, and
that in a fourth switching state this first transfer unit (3, 13) is then discharged again and the energy storage device (2) is charged in this case,
**characterized in that**
that the electrical energy is transferred step-by-step between the energy storage device (2) and the piezoelectric MEMS sound transducer (4), so that the electrical energy is transferred in multiple portions for both charging and energy recovery, respectively.

8. The circuit as claimed in the preceding claim, **characterized in that** the circuit (1) comprises a first transfer unit (3), wherein a first current path (6) extends through the first transfer unit (3).

9. The circuit as claimed in claim 8, **characterized in that** the circuit (1) comprises a second transfer unit (13), wherein a second current path (14) extends through the second transfer unit (13).

10. The circuit as claimed in the claims 8 and 9, **characterized in that** the first transfer unit (3) and the second transfer unit (13) are situated in a parallel circuit (5), so current can be applied to the first current path (6) and to the second current path (14) independently of one another.

11. The circuit as claimed in one or multiple of the preceding claims 8 to 10, **characterized in that** the first transfer unit (3) and the piezoelectric MEMS sound transducer (4) are situated with respect to one another in such a way that a first circuit (8) is formed, and
that the second transfer unit (13) and the piezoelectric MEMS sound transducer (4) are situated with respect to one another in such a way that a second circuit (15) is formed.

12. The circuit as claimed in one or multiple of the preceding claims 8 to 11, **characterized in that** the first transfer unit (3) and/or the second transfer unit (13) comprise an energy storage unit, in particular a coil having an inductance, so that the electrical energy can be stored in the transfer units (3, 13) and/or
that the energy store (2) comprises a capacitor having a capacitance, so that the electrical energy can be stored therein and/or
that the energy store (2), the first transfer unit (3), the second transfer unit (13), and/or the piezoelectric MEMS sound transducer (4) form an electrical, in particular resonant, oscillating circuit, so the electrical energy stored in the electrical oscillating circuit is capable of oscillating between the particular components.

13. The circuit as claimed in one or multiple of the preceding claims 8 to 12, **characterized in that** the circuit (1) comprises a controller (17) and a plurality of switching units (10) and/or switches (9), in particular transistors, and/or diodes (16), so that the particular switching states can be formed, wherein the switching units (10) and/or switches (9) can be activated with the aid of the controller (17) in such a way that the first current path (6), the second current path (14), the first circuit (8), and/or the second circuit (15) can be interrupted or made to be conductive, so that an electric current in the particular current paths (6, 7, 14) and/or circuits (8, 15) can be interrupted and/or conducted.

14. An integrated circuit, in particular an ASIC, which comprises a circuit (1) which is designed as claimed in at least one or multiple of the preceding claims 7 to 13.

## Revendications

1. Procédé pour exploiter un transducteur acoustique piézoélectrique MEMS (4), en particulier un haut-parleur MEMS fonctionnant dans le spectre des longueurs d'onde audibles et/ou dans la plage ultrasonique, dans lequel de l'énergie électrique est stockée dans au moins un accumulateur d'énergie (2) et cette énergie électrique est transférée entre l'accumulateur d'énergie (2) et le transducteur acoustique piézoélectrique MEMS (4) indirectement, via au moins une première unité de transfert (3, 13),
dans lequel au moins la première unité de transfert (3, 13) et le transducteur acoustique piézoélectrique MEMS (4) sont disposés l'un par rapport à l'autre dans un couplage parallèle (5) et des unités de commutation (10) et/ou des commutateurs (9) sont commutés par une commande (17) de sorte que,
pour exploiter le transducteur acoustique piézoélectrique MEMS (4), au moins la première unité de transfert (3), dans un premier état de commutation, est d'abord chargée par l'accumulateur d'énergie (2), ensuite, dans un deuxième état de commutation, cette première unité de transfert (3) est à nouveau déchargée et le transducteur acoustique piézoélectrique MEMS (4) est pendant ce temps chargé,
pour la récupération d'énergie, le transducteur acoustique piézoélectrique MEMS (4), dans un troisième état de commutation, est à nouveau déchargé et au moins la première unité de transfert (3, 13) est pendant ce temps chargée, et
ensuite, dans un quatrième état de commutation, cette première unité de transfert (3, 13) est à nouveau déchargée et l'accumulateur d'énergie (2) est pendant ce temps chargé,
**caractérisé en ce que**
l'énergie électrique est transférée pas à pas entre l'accumulateur d'énergie (2) et le transducteur acoustique piézoélectrique MEMS (4), de sorte que l'énergie électrique est transférée en plusieurs portions respectivement pour la charge et pour la récupération d'énergie.

2. Procédé selon la revendication précédente, **caractérisé en ce que**, pour exploiter le transducteur acoustique piézoélectrique MEMS (4), l'énergie électrique provenant de l'accumulateur d'énergie (2), dans le premier état de commutation, est d'abord chargée via un premier trajet de courant (6) au moins partiellement sur la première unité de transfert (3) et ensuite, l'énergie électrique, dans le deuxième état de commutation, est transférée au moins partiellement dans un premier circuit électrique (8) de la première unité de transfert (3) au transducteur acoustique piézoélectrique MEMS (4) et
**en ce que**, pour la récupération d'énergie, l'énergie électrique du transducteur acoustique piézoélectrique MEMS (4), dans le troisième état de commutation, est d'abord chargée dans le premier circuit électrique (8) depuis le transducteur acoustique piézoélectrique MEMS (4) sur la première unité de transfert (3) et est ensuite, dans le quatrième état de commutation, transférée sur l'accumulateur d'énergie (2) via le premier trajet de courant (6).

3. Procédé selon l'une quelconque des revendications précédentes, **caractérisé en ce que** dans le procédé, l'énergie électrique est transférée entre l'accumulateur d'énergie (2) et le transducteur acoustique piézoélectrique MEMS (4) au moyen d'une deuxième unité de transfert (13) et **en ce que**, pour exploiter le transducteur acoustique piézoélectrique MEMS (4), l'énergie électrique est d'abord chargée depuis l'accumulateur d'énergie (2) dans un cinquième état de commutation au moins partiellement sur la deuxième unité de transfert (13) via au moins un deuxième trajet de courant (14), et ensuite l'énergie électrique est chargée au moins partiellement, dans un sixième état de commutation, dans un deuxième circuit de courant (15), de la deuxième unité de transfert (13) sur le transducteur acoustique piézoélectrique MEMS (4), et **en ce que**, pour la récupération d'énergie, l'énergie électrique du transducteur acoustique piézoélectrique MEMS (4), dans un septième état de commutation, est d'abord chargée dans le deuxième circuit électrique (15) depuis le transducteur acoustique piézoélectrique MEMS (4) sur la deuxième unité de transfert (13) et est ensuite, dans un huitième état de commutation, transférée sur l'accumulateur d'énergie (2) via le deuxième trajet de courant (14).

4. Procédé selon les revendications 2 et 3 précédentes, **caractérisé en ce que**, pendant le transfert de l'énergie électrique dans le premier circuit électrique (8) de la première unité de transfert (3) au transducteur acoustique piézoélectrique MEMS (4), de l'énergie électrique est transférée sur le deuxième trajet de courant (14) de l'accumulateur d'énergie (2) à la deuxième unité de transfert (13), et
**en ce que** pendant le transfert de l'énergie électrique dans le deuxième circuit électrique (15) de la deuxième unité de transfert (13) au transducteur acoustique piézoélectrique MEMS (4), de l'énergie électrique est transférée sur le premier trajet de courant (6) de l'accumulateur d'énergie (2) à la première unité de transfert (3).

5. Procédé selon les revendications 2 à 4 précédentes, **caractérisé en ce que** le circuit (1) comprend une pluralité d'unités de commutation (10) et/ou de commutateurs (9) qui sont ouverts et/ou fermés de sorte que et/ou une pluralité de diodes (16) qui sont disposées de sorte que les différents états de commutation peuvent être réalisés, dans lequel le premier trajet de courant (6), le deuxième trajet de courant (14), le premier circuit électrique (8) et/ou le deuxième circuit électrique (15) deviennent ou sont interrompus et/ou conducteurs, de sorte que l'énergie électrique peut être transférée entre l'accumulateur d'énergie (2), la première unité de transfert (3), la deuxième unité de transfert (13) et/ou le transducteur acoustique piézoélectrique MEMS (4).

6. Procédé selon les revendications 1 à 4 précédentes, **caractérisé en ce que** l'accumulateur d'énergie (2), la première unité de transfert (3), la deuxième unité de transfert (13) et/ou le transducteur acoustique piézoélectrique MEMS (4) forment un circuit oscillant électrique, en particulier résonant, dans lequel les commutateurs (9) et/ou les unités de commutation (10) sont de préférence commuté(e)s de sorte que la commutation s'effectue dans un passage par zéro du courant du circuit oscillant respectif.

7. Circuit avec
des unités de commutation (10) et/ou des commutateurs (9),
une commande (17) pour commuter les unités de commutation (10) et/ou les commutateurs (9),
au moins un accumulateur d'énergie (2) dans lequel peut être accumulée de l'énergie électrique,
un transducteur acoustique piézoélectrique MEMS (4), en particulier un haut-parleur MEMS fonctionnant dans le spectre des longueurs d'onde audibles et/ou dans la plage ultrasonique, et
au moins une première unité de transfert (3, 13) au moyen de laquelle l'énergie électrique peut être transférée entre l'accumulateur d'énergie (2) et le transducteur acoustique piézoélectrique MEMS (4),
dans lequel au moins la première unité de transfert (3, 13) et le transducteur acoustique piézoélectrique MEMS (4) sont disposés l'un par rapport à l'autre dans un couplage parallèle (5) et
dans lequel le circuit (1) est exploité au moyen de la commande (17) de sorte que,
pour exploiter le transducteur acoustique piézoélectrique MEMS (4), au moins la première unité de transfert (3), dans un premier état de commutation, est d'abord chargée par l'accumulateur d'énergie (2), ensuite, dans un deuxième état de commutation, cette première unité de transfert (3) est à nouveau déchargée et le transducteur acoustique piézoélectrique MEMS (4) est pendant ce temps chargé,
pour la récupération d'énergie, le transducteur acoustique piézoélectrique MEMS (4), dans un troisième état de commutation, est à nouveau déchargé et au moins la première unité de transfert (3, 13) est pendant ce temps chargée, et
ensuite, dans un quatrième état de commutation, cette première unité de transfert (3, 13) est à nouveau déchargée et l'accumulateur d'énergie (2) est pendant ce temps chargé,
**caractérisé en ce que**
l'énergie électrique est transférée pas à pas entre l'accumulateur d'énergie (2) et le transducteur acoustique piézoélectrique MEMS (4), de sorte que l'énergie électrique est transférée en plusieurs portions respectivement pour la charge et pour la récupération d'énergie.

8. Circuit selon la revendication précédente, **caractérisé en ce que** le circuit (1) comprend la première unité de transfert (3), dans lequel un premier trajet de courant (6) passe à travers la première unité de transfert (3).

9. Circuit selon la revendication 8, **caractérisé en ce que** le circuit (1) comprend une deuxième unité de transfert (13), dans lequel un deuxième trajet de courant (14) passe à travers la deuxième unité de transfert (13).

10. Circuit selon les revendications 8 et 9, **caractérisé en ce que** la première unité de transfert (3) et la deuxième unité de transfert (13) sont disposées dans un couplage parallèle (5), de sorte que le premier trajet de courant (6) et le deuxième trajet de courant (14) peuvent être soumis au courant indépendamment l'un de l'autre.

11. Circuit selon l'une quelconque ou plusieurs des revendications 8 à 10 précédentes, **caractérisé en ce que** la première unité de transfert (3) et le transducteur acoustique piézoélectrique MEMS (4) sont disposés l'un par rapport à l'autre de sorte qu'il se forme un premier circuit électrique (8), et
**en ce que** la deuxième unité de transfert (13) et le transducteur acoustique piézoélectrique MEMS (4) sont disposés l'un par rapport à l'autre de sorte qu'il se forme un deuxième circuit électrique (15).

12. Circuit selon l'une quelconque ou plusieurs des revendications 8 à 11 précédentes, **caractérisé en ce que** la première unité de transfert (3) et/ou la deuxième unité de transfert (13) comporte(nt) une unité d'accumulation d'énergie, en particulier une bobine avec une inductance, de sorte que l'énergie électrique peut être accumulée dans les unités de transfert (3, 13), et/ou **en ce que** l'accumulateur d'énergie (2) comprend un condensateur avec une capacité, de sorte que l'énergie électrique peut y être accumulée, et/ou **en ce que** l'accumulateur d'énergie (2), la première unité de transfert (3), la deuxième unité de transfert (13) et/ou le transducteur acoustique piézoélectrique MEMS (4) forment un circuit oscillant électrique, en particulier résonant, de sorte que l'énergie électrique accumulée dans le circuit oscillant électrique peut osciller entre les différents composants.

13. Circuit selon l'une quelconque ou plusieurs des revendications 8 à 12 précédentes, **caractérisé en ce que** le circuit (1) présente une commande (17) et une pluralité d'unités de commutation (10) et/ou de commutateurs (9), en particulier des transistors, et/ou des diodes (16), de sorte que les différents états de commutation peuvent être réalisés, dans lequel les unités de commutation (10) et/ou les commutateurs (9) peuvent être commandés au moyen de la commande (17) de sorte que le premier trajet de courant (6), le deuxième trajet de courant (14), le premier circuit électrique (8) et/ou le deuxième circuit électrique (15) est/sont interruptibles et/ou conductibles, de sorte qu'un courant électrique peut être interrompu et/ou conduit dans les différents trajets de courant (6, 7, 14) et/ou circuits électriques (8, 15).

14. Circuit intégré, en particulier ASIC, qui comprend un circuit (1) qui est configuré selon au moins une ou plusieurs des revendications 7 à 13 précédentes.
